# EUROPEAN PATENT APPLICATION

(11) **EP 2 692 761 A1**
(43) Date of publication of application: **05.02.2014**
(21) Application number: 12764390.6
(22) Date of filing: 30.03.2012
(51) Int. Cl.: C08G 61/12, C08K 3/04, C08L 65/00, H01L 51/42

(54) **BLOCK COPOLYMER AND PHOTOELECTRIC CONVERSION ELEMENT**

(30) Priority: 31.03.2011 JP 2011080317
(71) Applicant: Kuraray Co., Ltd., Okayama 710-0801 (JP)
(72) Inventor: IZAWA, Takafumi, Kurashiki-shi Okayama 710-0801 (JP); SHIBUYA, Hiromasa, Kurashiki-shi Okayama 710-0801 (JP); SUGIOKA, Takashi, Kurashiki-shi Okayama 710-0801 (JP); INAGAKI, Takuya, Kurashiki-shi Okayama 710-0801 (JP); MORIHARA, Yasushi, Kurashiki-shi Okayama 710-0801 (JP); NAKAHARA, Atsuhiro, Kurashiki-shi Okayama 710-0801 (JP); FUJITA, Akio, Kurashiki-shi Okayama 710-0801 (JP); OGI, Hiroyuki, Kurashiki-shi Okayama 710-0801 (JP)
(74) Representative: Müller-Boré & Partner Patentanwälte PartG mbB
(86) International application number: PCT/JP2012/058618
(87) International publication number: WO 2012/133794

(57) **Abstract**

Provided are: a conjugated block copolymer capable of increasing the amount of optical absorption by a photoelectric conversion active layer and controlling the morphology thereof and capable of achieving excellent photoelectric conversion efficiency; and a photoelectric conversion element comprising a composition including an electron accepting material using this kind of conjugated block polymer.

A π-electron conjugated block copolymer comprises: a polymer block (A) and a polymer block (B), each of which involves a monomer unit having at least one fused π-conjugated skeleton including at least one thiophene ring in one part of the chemical structure thereof, the polymer block (A) and the polymer block (B) have different monomer units from each other.

## Description

### TECHNICAL FIELD

The present invention relates to a novel π-electron conjugated block copolymer having a self-assembly (or self-organization) property, and to a photoelectric conversion element made of the copolymer.

### BACKGROUND ART

Organic thin film solar cells which are produced by coating using solvent-soluble polymer materials have currently attracted much attention, because they can be produced at low cost when compared with inorganic solar cells which are mainstream solar cells that have been made of polycrystalline silicon, amorphous silicon, compound semiconductor, etc.

The organic thin film solar cell, which is one of the photoelectric conversion elements, generally has a photoelectric conversion active layer which has a bulk hetero-junction structure formed with a mixture of a conjugated polymer and an electron accepting material. As a specific example, there is an organic thin film solar cell having a photoelectric conversion active layer including a mixture of poly (3-hexylthiophene) (P3HT) as a conjugated polymer and [6,6]-phenyl C₆₁ butyric acid methyl ester (PCBM) as a fullerene derivative which is an electron accepting material (see Non-Patent Document 1 below).

In the bulk hetero-junction structure, incident light entering from the transparent electrode is absorbed by an electron accepting material and/or a conjugated polymer to generate an exciton which is a bound state of an electron and an electron hole. The generated exciton moves to the hetero-junction interface where the electron accepting material abuts on the conjugated polymer, to charge-separate into electrons and holes. Holes and electrons are then each transported through the conjugated polymer phase and the electron accepting material phase, and are then taken out from an electrode. Therefore, in order to improve the photoelectric conversion efficiency of the organic thin film solar cells, the key point is how to control the morphology of a bulk hetero-junction structure which is formed through phase separation of the conjugated polymer and the electron accepting material.

Poly (3-hexylthiophene) absorbs light of the visible light region. However, many conjugated polymers having absorption at a longer wavelength region (up to a near infrared region) (hereinafter meant as a narrow-band gap polymer) have already been proposed (see Non-Patent Documents 2 and 3, listed below). However, the narrow-band gap polymers have poor crystallinity when compared with poly(3-hexylthiophene), so that there is a difficulty in controlling their morphology, being undesirable.

To realize high photoelectric conversion efficiency, organic thin film solar cells have been proposed in which conjugated block copolymer of narrow band gap polymers are used (Patent Document 1). In this document, a fluorene skeleton or framework is used as a main chain skeleton.

### [Prior Art Documents]

### [Patent Document]

[Patent Document 1] Japan Patent Application Publication No. 2008-266459

### [Non-Patent Documents]

[Non-Patent Document 1] Angew. Chem. Int. Ed, 47, p.58 (2008)
[Non-Patent Document 2] Adv. Mater., 22, E6 (2010)
[Non-Patent Document 3] Adv. Mater., 22, p.3839 (2010)

### SUMMARY OF THE INVENTION

### Problems to be solved by the Invention

In the organic thin film solar cells using conjugated block copolymers of narrow band gap polymers described in the prior art documents mentioned above, crystallinity decreases due to twisting of the polymer main chain, so that morphology control becomes difficult. Further, since the twisting is large, the light absorption of the long wavelength region also becomes difficult, and the photoelectric conversion efficiency has remained 2 - 3 percent. The present invention was made to solve the above mentioned problems, to provide a conjugated block copolymer capable of an increase in the amount of optical absorption of the photoelectric conversion active layer, controlling the morphology and realizing an excellent photoelectric conversion efficiency, and to provide a photoelectric conversion element composed of a composition containing an electron accepting material and the conjugated block copolymer.

### MEANS FOR SOLVING THE PROBLEMS

The present invention which was made to achieve the objects described above is a π-electron conjugated block copolymer comprises:
a polymer block (A) and a polymer block (B), each of which involves a monomer unit having at least one fused *π*-conjugated skeleton including at least one thiophene ring in one part of the chemical structure thereof:
   the polymer block (A) and the polymer block (B) have different monomer units from each other in such a manner that:
heteroaryl skeletons that constitute main chains of the monomer units are different from each other; a numerical difference between carbon atoms of substituents of the monomer units is 4 or more; or a sum of hetero atoms in the substituent of the monomer unit of the polymer block (A) is 2 or less, and a sum of hetero atoms in the substituent of the monomer unit of the polymer block (B) is 4 or more.

The present invention is the π-electron conjugated block copolymer, wherein the polymer block (A) and the polymer block (B) include a monomer unit of -a-b-,
- a- is a monomer unit having any one of groups represented by the following formulas (1) - (6), 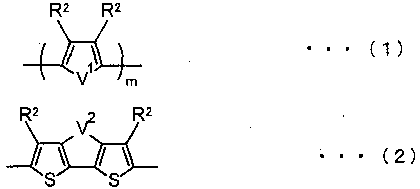 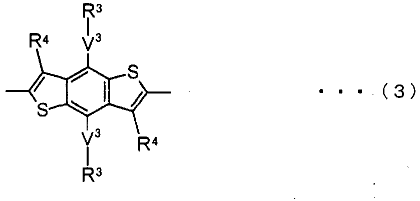 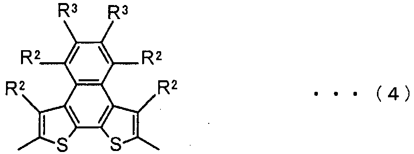 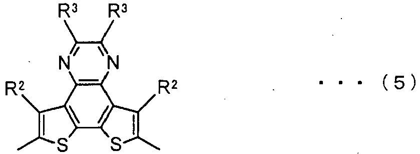 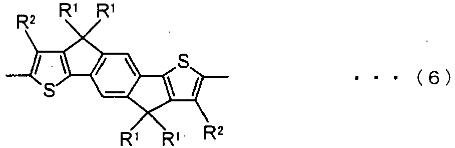
and -b- is a monomer unit having any one of groups represented by the following formulas (7)-(17),

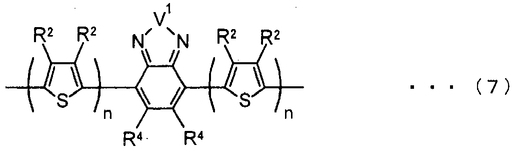

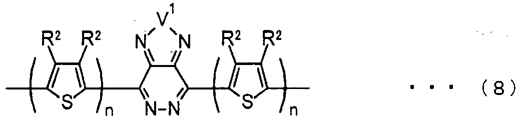

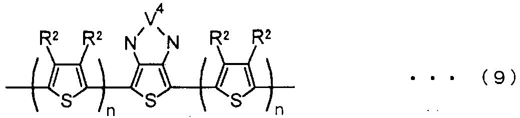

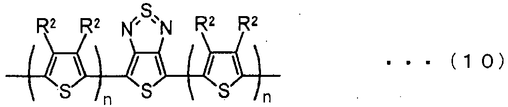

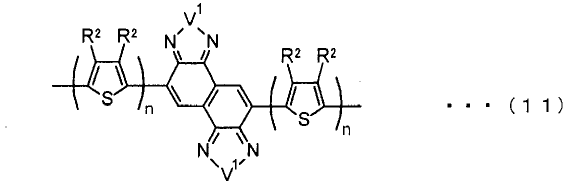

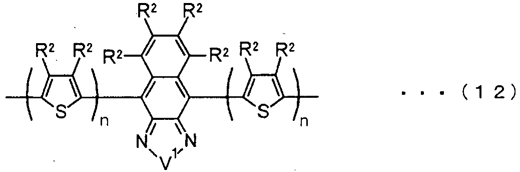

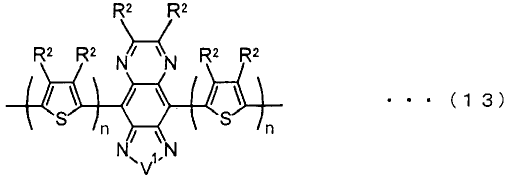

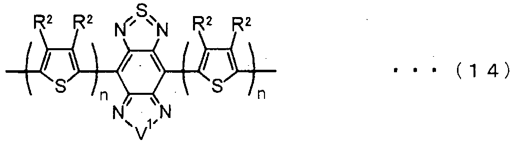

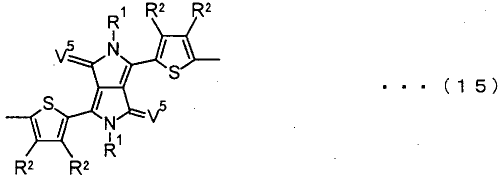

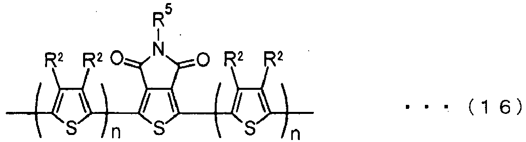

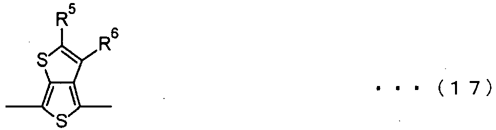

Here, at least either -a- or -b- has a group having a fused π-conjugated skeleton containing in one part of chemical structure thereof the thiophene ring, and in the formulas (1) - (17), V¹ is a nitrogen (-NR¹), oxygen (-O-) or sulfur (-S-), V² is a carbon (-CR¹₂-), nitrogen (-NR¹-), silicon (-SiR¹₂-) or germanium (-GeR¹₂-), V³ is an aryl group or heteroaryl group represented by -(Ar)ₙ-, V⁴ is a nitrogen (-NR¹-), oxygen (-O-) or -CR² = CR²-, and V⁵ is an oxygen (-O-) or sulfur (-S-).

R¹ is an alkyl group having 1 - 18 carbon atoms which may be each independently substituted, R² is each independently a hydrogen atom, a carbon atom or an alkyl group having 1 - 18 carbon atoms which may be substituted, R³ is an alkoxy group or an alkyl group having 1 - 18 carbon atoms which may be each independently substituted, R⁴ is each independently a hydrogen atom, a halogen atom, or an aryl group or an alkyl group having 1 - 18 carbon atoms which may be substituted; R⁵ is an alkyl or aryl or alkylcarbonyl or alkyloxycarbonyl group having 1 - 18 carbon atoms which may be substituted; and R⁶ is a hydrogen atom or a halogen atom. m is an integer of 1 - 3, and n is an integer of 0 - 3.

The present invention is the π-electron conjugated block copolymer, wherein the monomer unit -a-b- includes any one of monomer units selected from the following formulas (18) - (28). 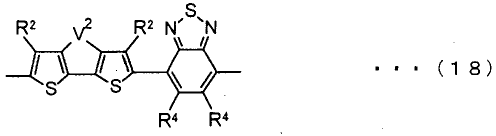 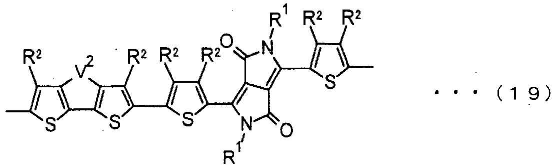 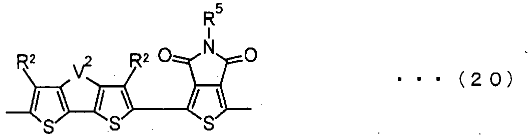 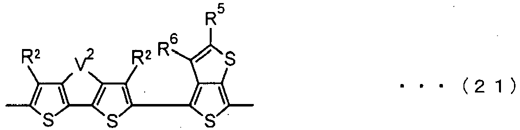 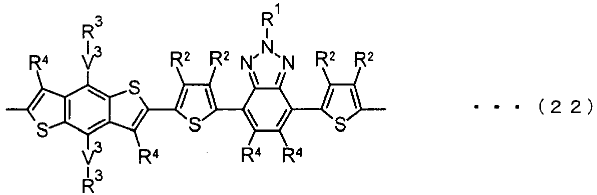 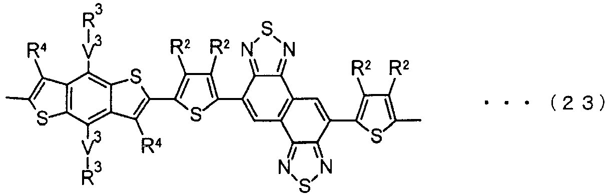 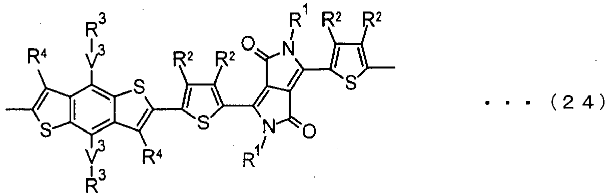 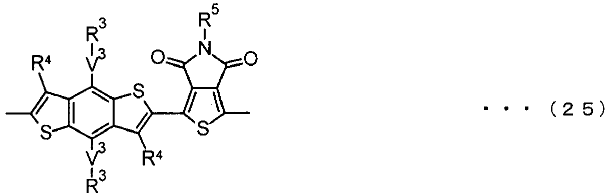 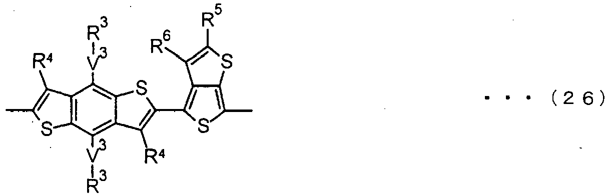 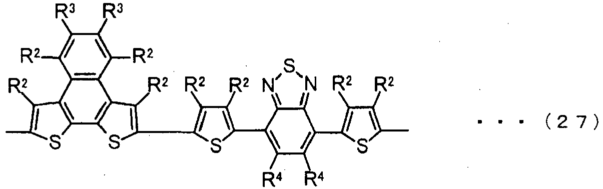 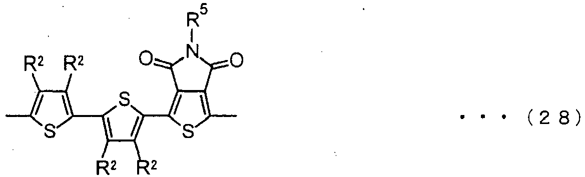 In the formulas (18) - (28), V² represents a carbon (-CR¹₂-), nitrogen (-NR¹-), silicon (-SiR¹₂-), or germanium (-GeR¹₂-); V³ is an aryl or heteroaryl group represented by -(Ar)n-.

R¹, R², R³, R⁴, R⁵ and R⁶ are the same meanings as defined above.

n represents an integer of 0 - 3.

The present invention is the π-electron conjugated block copolymer, wherein at least one of the polymer block (A) or the polymer block (B) is a random copolymer comprising a plural types of the monomer units.

The present invention is the π-electron conjugated block copolymer, wherein the random copolymer comprises a plurality of different monomer units -a-b- which are different from each other.

The present invention is the π-electron conjugated block copolymer, of which a number average molecular weight is range of 1000-200000 g/mol.

The present invention which was made to achieve the objects described above is a composition comprising an electron accepting material and the π-electron conjugated block copolymer described above.

Similarly, the present invention which was made to achieve the object of the present invention is a photoelectric conversion element which has a layer comprising the composition described above.

The present invention is the photoelectric conversion element, wherein the electron accepting material is a fullerene or/and a derivative thereof.

### Effects of the Invention

The present π-electron conjugated block copolymer forms a three-dimensional nanophase separation structure in which the π-electron conjugated block copolymer phase and the electron accepting material phase are formed to be a continuous phase separation structure through self-organization. Accordingly, charge generation efficiency and charge arrival efficiency to an electrode is improved, and performance of the photoelectric conversion element can be substantially improved.

### Mode for Carrying Out the Invention

Preferred embodiments for carrying out the present invention will be precisely explained below, but the scope of the present invention is not limited to these embodiments.

The present π-electron conjugated block copolymer comprises a polymer block (A) and a polymer block (B) involving a monomer unit having at least one fused π-conjugated skeleton having at least one thiophene ring in one part of the chemical structure thereof. As the fused π-conjugated skeleton having at least one thiophene ring, for example, cyclopentadithiophene, dithienopyrrole, dithienosilole, dithienogermole, benzodithiophene, naphthodithiophene, etc. are exemplified. To control the solubility and the polarity of the π-electron conjugated block copolymer, a substituent is introduced to the main chain skeleton by a covalent bond.

As the monomer unit that constitutes the polymer block (A) and the polymer block (B), the monomer unit represented by the formulas (1) - (17) is preferably used. Among them, the polymer block (A) or the polymer block (B) including the monomer unit -a-b- is preferably used. Here, -a- is preferably a monomer unit having any group (a group comprising a donor type unit) represented by the formulas (1) - (6), and -b- is preferably a monomer unit having any one of group (a group comprising a unit having a ring that serves as an acceptor) represented by the formulas (7) - (17). -a- has more preferably any group represented by the formulas (1), (2), (3) and (4), and -b- has more preferably any group represented by the formulas (7), (11) and (15) - (17).

In the formulas (1) - (17), V¹ is a nitrogen (-NR¹-), oxygen (-O-) or sulfur (-S-), V² is a carbon (-CR¹₂-), nitrogen (-NR¹-), silicon (-SiR¹₂-) or germanium (-GeR¹₂-), V³ is an aryl group or heteroaryl group represented by -(Ar)ₙ-, V⁴ is a nitrogen (-NR¹-), oxygen (-O-) or -CR²=CR²-, V⁵ is oxygen (-O-) or sulfur (-S-). As V¹, sulfur is particularly preferred. In the formula (3), the monocyclic or polycyclic (hetero) aryl group (n is an integer of 0 - 3) which is represented by -(Ar)ₙ- that represents V³ constitutes a portion of the main chain skeleton of the monomer unit. As V³, thiophene ring is especially preferable.

Further, as specific examples of the monomer unit that constitutes -a-b-, for example, monomer units represented by the formulas (18) - (28) are exemplified. For example, a monomer unit represented by a formula -(2)-(7)- is a formula represented by the formula (18), similarly, -(2)-(15)- is represented by (19), -(2)-(16)- is represented by (20), -(2)-(17)- is represented by (21), -(3)-(7)- is represented by (22), -(3)-(11)- is represented by (23), -(3)-(15)- is represented by (24), -(3)-(16)- is represented by (25), -(3)-(17)- is represented by (26), -(4)-(7)- is represented by (27), and -(1)-(16)- is represented by (28). Note that in the present invention, as long as a polymer has a plurality of certain repeating structures in the polymer, a plurality of bonded structures (or, for example, a monomer unit of -a-b-) of a heterocycle comprising a fused π-conjugated skeleton including thiophene ring, is also regarded as one of the monomer unit. In other words, as long as the substituent group is the same, a complete alternating copolymer block of the monomer unit -a- and the other monomer unit -b- is considered to be a homopolymer block of the monomer unit -a-b-.

In the polymer block (A) and the polymer block (B) of the present invention, the total number of carbon atoms of the ring structure (the carbon numbers on a substituent are excluded) in a monomer unit including the -a-b- type monomer unit is preferably in the range of 6 - 40.

Preferable specific examples of -a- represented by the formulas (1) - (6) are not particularly limited, but, for example, groups represented by the following formulas (29) - (34) are exemplified.

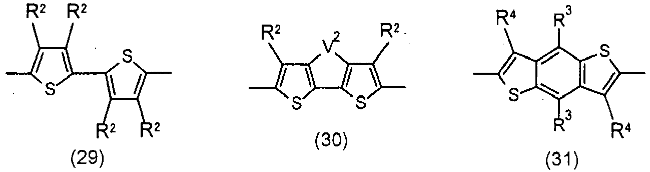

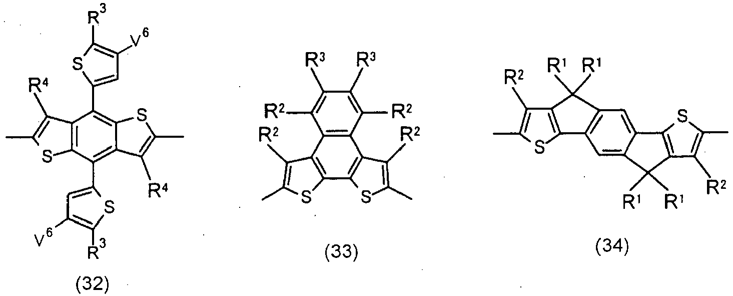

In the formulas, V², R², R³ and R⁴ are the same meanings as described above. V⁶ is each independently a hydrogen atom or R³.

As a preferred embodiment of -b- represented by the formulas (7) - (17), are not particularly limited, but, for example, groups represented by the following formulas (35) - (40) can be exemplified.

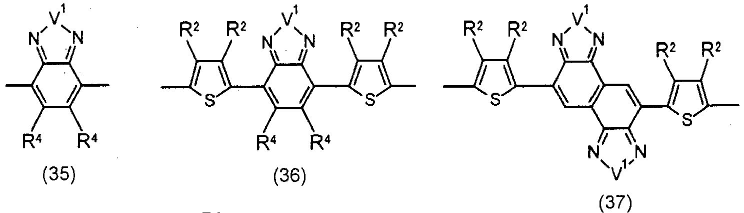

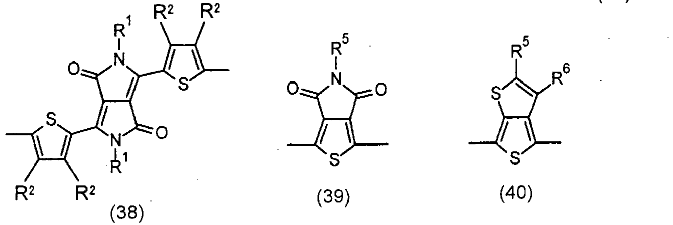

In in the formulas, V¹, R², R⁴, R⁵ and R⁶ are the same meanings as defined above.

Further, as a preferred embodiment of -a-b- represented by the formulas (18) - (28), are not particularly limited, but, for example, groups represented by the following formulas (41) - (57) can be exemplified.

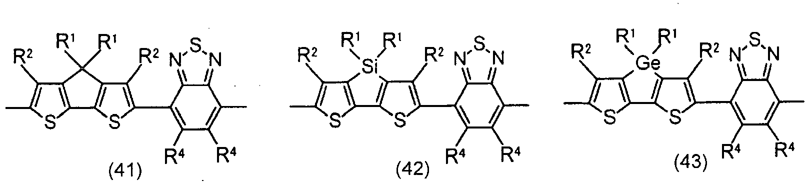

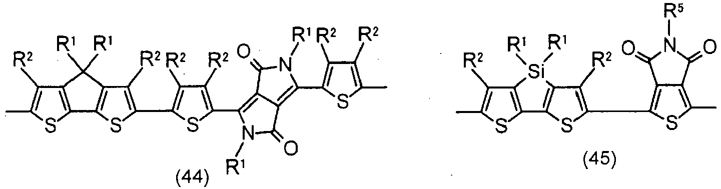

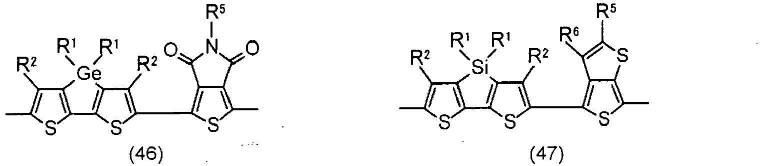

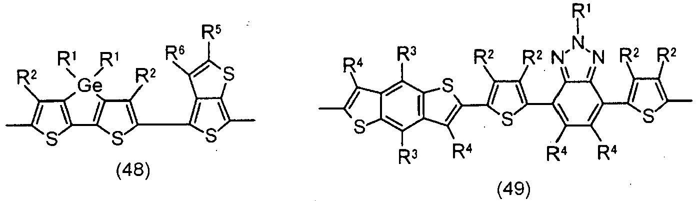

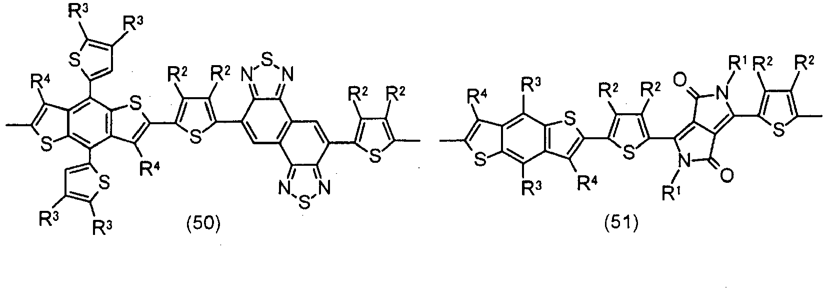

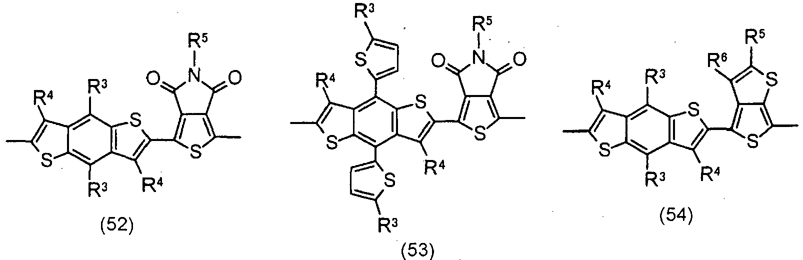

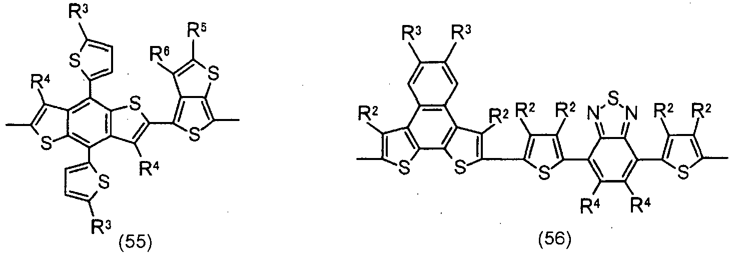

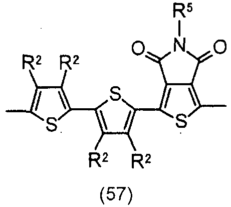

In the formulas, R¹ - R⁶ are the same meanings as defined above.

The polymer block (A) and the polymer block (B) may have a substituent represented by R¹ - R⁶ described above. R¹ is an alkyl group having 1 - 18 carbon atoms which may be each independently substituted, R² is each independently a hydrogen atom or an alkyl group having 1 - 18 carbon atoms which may be substituted, R³ is an alkoxy group or an alkyl group having 1 - 18 carbon atoms which may be each independently substituted, R⁴ is each independently a hydrogen atom, a halogen atom, an aryl group or an alkyl group having 1 - 18 carbon atoms which may be substituted, R⁵ is an alkyl group, an aryl group, an alkylcarbonyl group, or an alkyloxycarbonyl group having 1 - 18 carbon atoms which may be substituted, and R⁶ is a hydrogen atom or a halogen atom. If the monomer unit has substituents at a plurality of locations, each may be different from each other.

As the alkyl group having 1 - 18 carbon atoms, for example, methyl group, ethyl group, n-propyl group, isopropyl group, n-butyl group, isobutyl group, sec-butyl group, tert-butyl group, n-pentyl group, isopentyl group, neopentyl group, tert-pentyl group, n-hexyl group, isohexyl group, 2-ethylhexyl group, n-heptyl group, n-octyl group, n-nonyl group, n-decyl group, cyclopropyl group, cyclopentyl group, cyclohexyl group, cyclooctyl group and the like, are exemplified.

As an example of the alkoxy group having 1 - 18 carbon atoms, for example, methoxy group, ethoxy group, n-propyloxy group, isopropyloxy group, n-butoxy group, n-hexyloxy group, cyclohexyloxy group, n-octyloxy group, n-decyloxy group, n-dodecyloxy group and the like, are exemplified.

As an example of the aryl group, for example, phenyl group, 1-naphthyl group, 2-naphthyl group, 1-anthracenyl group, 2-anthracenyl group, 9-anthracenyl group, etc. are exemplified, and those groups may further have a substituent such as alkyl group, alkoxy groups, etc. As examples of heteroaryl groups, for example, pyridyl group, thienyl group, furyl group, pyrrolyl group, quinolyl group, isoquinolyl group, etc. are exemplified.

Substituents represented by R¹ - R⁵ that could exist in the polymer block (A) and the polymer block (B) may further be substituted with an alkyl group, an alkoxy group, a halogen atom, a hydroxyl group, an amino group, a thiol group, a silyl group, an ester group, an aryl group, heteroaryl group, etc. The alkyl group or alkoxy group may be a straight chain, a branched chain or an alicyclic chain

As the alkyl group, alkoxy group, aryl group and heteroaryl group, which may substitute the substituents R¹ - R⁵ of the polymer block (A) and the polymer block (B), for example, the groups that are already listed above are exemplified.

As a halogen atom, a fluorine atom, chlorine atom, bromine atom and iodine atom are exemplified. As an alkyl group substituted with the halogen atom, for example, ω-bromo alkyl group, perfluoroalkyl group and the like are exemplified.

As the amino group, for example, a primary or a secondary amino group such as dimethylamino group, diphenylamino group, methylphenylamino group, methylamino group, ethyl amino group, etc. are exemplified.

As the thiol group, for example, mercapto group, alkylthio group, etc. are exemplified. As the silyl group, for example, trimethylsilyl group, triethylsilyl group, tripropylsilyl group, triisopropylsilyl group, dimethylisopropylsilyl group, dimethyl-tert-butylsilyl group, etc. are exemplified.

As the ester groups, for example, methoxycarbonyl group, ethoxycarbonyl group, propoxycarbonyl group, isopropoxycarbonyl group, tert-butoxycarbonyl group, phenoxycarbonyl group, acetyloxy group, benzoyloxy group, etc. are exemplified.

Monomer units that constitute the polymer block (A) and the polymer block (B) are, in the present invention, different from each other. That "the monomer units are different from each other" means the monomer units should meet at least one of following conditions:
the heteroaryl skeletons that constitute the main chains of the monomer units are different from each other;
a numerical difference between carbon atoms of substituents of the monomer units is 4 or more; and
a sum of the hetero atoms in the substituent of the monomer unit of the polymer block (A) is 2 or less, and a sum of the hetero atoms in the substituent of the monomer unit of the polymer block (B) is 4 or more.

Since the difference between the monomer units each of which constitutes the polymer block (A) or the polymer block (B) causes the π-electron conjugated block copolymer of the present invention to perform the self-assembly in the composition based on the presence or absence of affinity between the electron accepting material and the π-electron conjugated block copolymer.

"The heteroaryl skeletons constituting the main chains are different from each other" means that "at least one part of the main chain skeletons other than the substituents are different from each other." In this case, it is not necessary that the substituents are identical with each other. For example, in the polymer block (A) and the polymer block (B), if -a- or -b- in the monomer unit of -a-b- is different from each other, the -a-b- can be used in the polymer block (A) and the polymer block (B). Even in a case where the same -a-b- is used for the polymer block (A) and the polymer block (B), when V¹ - V⁵ are different from each other, the same -a-b- can be preferably used.

Further, "a numerical difference between carbon atoms of the substituents of monomer unit is 4 or more" means that "a difference between the total number of the carbon atoms of the substituent in the monomer unit for polymer block (A) and the total number of carbon atoms of the substituent in the monomer unit for polymer block (B) is 4 or more." When the difference in the carbon number is less than 4, a difference in polarity between the polymer block (A) and the polymer block (B) becomes small, so that there is a tendency that the morphology control cannot be performed sufficiently. When compared between any one of substituents in the monomer unit of the polymer block (A) and the polymer block (B), it is preferable that the maximum difference is 4 or more.

"A sum of the hetero atoms in the substituent of the monomer unit of the polymer block (A) is 2 or less, and a sum of the hetero atoms in the substituent of the monomer unit of the polymer block (B) is 4 or more" means that "the total number of the hetero atoms in the substituent contained in the monomer unit of the polymer block (A) is 2 or less, and the total number of the hetero atoms in the substituent contained in the monomer unit of the polymer block (B) is 4 or more." When the number of the hetero atoms in the substituent of polymer block (A) and polymer block (B) are identical or a difference between the numbers is small, a difference in polarity between the polymer block (A) and the polymer block (B) becomes small, so that there is a tendency that the morphology control cannot be performed sufficiently. The hetero atom means an atom different from carbon atom. As the hetero atom, for example, a halogen atom, an oxygen atom, a sulfur atom, a silicon atom, and a nitrogen atom, etc. are exemplified. Among them, a halogen atom is preferable. Fluorine atom, chlorine atom, bromine atom and iodine atom are used as a halogen atom. Particularly, fluorine atom is preferably used.

Monomer units in the polymer block (A) or the polymer block (B) may be derived from only the single monomer having the same structure of the substituent. As long as the effects of the present invention are not impaired, another monomer may be used together. Further, each polymer block may be composed of a random copolymer made of a plurality of different types of monomer units. From the viewpoint of the photoelectric conversion characteristics, at least one of the polymer block (A) and the polymer block (B) is preferably a random copolymer. More preferably, the monomer unit that constitutes the random copolymer is made of the monomer unit -a-b-.

A bonding structure between the polymer block (A) and the polymer block (B) in the π-electron conjugated block copolymer of the present invention is not particularly limited, but as an example of the bonding type, for example, A-B type diblock copolymer, B-A type diblock copolymer, A-B-A type triblock copolymer, B-A-B type triblock copolymer, A-B-A-B type tetrablock copolymer, B-A-B-A type tetrablock copolymer, A-B-A-B-A type pentablock copolymer, B-A-B-A-B type pentablock copolymer, etc. are exemplified. The block copolymers of these types may be used alone or in combination of two or more bonding types.

Preferable weight ratio of the polymer block (A) to the polymer block (B) is 99 : 1 to 1 : 99, more preferably 95 : 5 to 5 : 95. When the weight ratio of the polymer block (A) or the polymer block (B) is too small, sufficient photoelectric conversion efficiency cannot be achieved. More preferably, the weight ratio is in the range of 90 : 10 to 10 : 90.

The number average molecular weight of the present π-electron conjugated block copolymer is preferably in the range of 1,000 - 200,000 g/mol in view of workability, crystallinity, solubility, and photoelectric conversion characteristics, more preferably from 5,000 - 200,000 g/mol. Solubility decreases and workability of the thin film decreases, when the number average molecular weight becomes too high. When the number average molecular weight becomes too low, crystallinity, stability, photoelectric conversion characteristics, etc. of the thin film decrease. The number average molecular weight means the polystyrene conversion number average molecular weight in gel permeation chromatography (GPC). The number average molecular weight of the π-electron conjugated block copolymer of the present invention can be determined by conventional GPC using solvent such as tetrahydrofuran (THF), chloroform, dimethylformamide (DMF), etc. However, solubility of some π-electron conjugated block copolymer of the present invention is low at around room temperature. In such cases, the number average molecular weight may be determined using high temperature GPC with solvent such as dichlorobenzene, trichlorobenzene, etc.

The π-electron conjugated block copolymer may include any polymer block (C) that is different from the polymer block (A) and the polymer block (B). As such polymer block (C), for example, a single block comprising -a- unit, a single block comprising -b- unit, or a block comprising a monomer unit of a component containing a monocyclic or a fused (hetero) arylene group which is other than the -a- unit and the -b- unit, can be exemplified. Further, a non-π-electron conjugated polymer may be contained as other polymer block (C). As a monomer that constitutes such block, for example, an aromatic vinyl compound (styrene, chloromethyl styrene, vinylpyridine, vinylnaphthalene, etc.), a (meth)acrylic acid ester (methyl (meth)acrylate, ethyl (meth)acrylate, hydroxyethyl (meth)acrylate, etc.), vinyl ester (vinyl acetate, vinyl propionate, vinyl butyrate, vinyl pivalate ester, etc.), an alpha hydroxy acid (lactic acid, glycolic acid, etc.), are exemplified.

The structure of the π-electron conjugated block copolymer of the present invention can be exemplified as follows when it includes a polymer block (C). As a structure in which the polymer block (A) is coupled or bonded contiguously with the polymer block (B), for example, A-B-C type triblock copolymer, B-A-C type triblock copolymer, C-A-B type triblock copolymer, C-B-A type tri-block copolymer, A-B-A-C type tetrablock copolymer, B-A-B-C type tetrablock copolymer, C-A-B-A type tetrablock copolymer, C-B-A-B type tetrablock copolymer, C-A-B-C type tetrablock copolymer, C-B-A-C type tetrablock copolymer, C-A-B-A-C type pentablock copolymer, C-B-A-B-C type pentablock copolymer, A-B-A-B-C type pentablock copolymer, B-A-B-A-C type pentablock copolymer, C-B-A-B-A type pentablock copolymer, and C-A-B-A-B type pentablock copolymer and the like, can be exemplified.

Further, the structure in which the polymer block (A) and the polymer block (B) are non-contiguously bonded is a term used to mean a structure in which the polymer block (C) is inserted between the polymer block (A) and the polymer block (B). As examples of the polymer block in which the polymer block (A) and the polymer block (B) is non-contiguously bonded, for example, A-C-B type triblock copolymer, B-C-A type triblock copolymer, A-C-B-A type tetrablock copolymer, A-B-C-A type tetrablock copolymer, B-C-A-B type tetra-block copolymer, B-A-C-B type tetrablock copolymer, A-B-C-A-B type pentablock copolymer, A-C-B-C-A type pentablock copolymer, B-A-C-B-A type pentablock copolymer, B-C-A-C-B type pentablock copolymer and the like can be exemplified. In addition to the above mentioned triblock, tetrablock or pentablock copolymers, another polymer block (A), polymer block (B) or polymer block (C) may be bonded.

When the present π-electron conjugated block copolymer includes polymer block (C), the percentage of the polymer block (C) in the block copolymer is preferably 40% by mass or less. The polymer block (C) is a non-π-electron conjugated block copolymer, from the viewpoint that it does not contribute to photoelectric conversion, the percentage is preferably less than 30% by mass or less, still more preferably 20% by mass or less.

As examples of manufacturing method of the present π-electron conjugated block copolymers, reaction steps and production methods will be described in detail below.

As the first method, the present π-electron conjugated block copolymer can be produced by separately synthesizing the polymer block (A) and the polymer block (B), then they are bonded to each other (hereinafter sometimes referred to as "bonding method"). As the second method, the polymer block (A) or the polymer block (B) is polymerized in the presence of the polymer block (A) or the polymer block (B) (hereinafter sometimes referred to as "macroinitiator method"). The bonding method and the macroinitiator method can be used as an optimal polymerization method depending on an intended type of the π-electron conjugated block copolymer.

Manufacturing of the π-electron conjugated block copolymer can be carried out by the bonding method, as shown in the following reaction formula (I). A compound A-M^{p} having a polymer block (A) which was prepared in advance and a compound B-X having polymer block (B) which was prepared in advance are subjected to a coupling reaction in the presence of a catalyst. Here, X and M^{p} is a terminal functional group of the polymer block.

A-M^{p} + B-X → A-B (I)

In the reaction formula (I), A and B represents a polymer block, X represents a halogen atom, M^{p} represents a boronic acid, a boronic acid ester, -MgX, -ZnX, -SiX₃ or -SnRa₃ (here, Ra is a straight chain alkyl group having 1 - 4 carbon atoms).

Terminal substituents of the polymer block (A) and the polymer block (B) may be swapped with each other, and as shown in the following reaction formula (II), the π-electron conjugated block copolymer can also be produced by carrying out a coupling reaction between a compound B-M^{p} having the polymer block (B) and a compound A-X having the polymer block (A) in the presence of a catalyst.

B-M^{p} + A-X → A-B (II)

In the reaction formula (II), A, B, X and M^{p} are the same meanings as defined above.

Next, the macroinitiator method will be explained. The macroinitiator method is a method for carrying out the polymerization of the polymer block (B) in the presence of compound A-X or A-M^{p} that has the polymer block (A) at an early or a middle stage of polymerization of the polymer block (B). It is also possible to carry out polymerization of the polymer block (A) in the presence of the compound B-X or B-M^{p} that has the polymer block (B) at an early or a middle stage of polymerization of the polymer block (A). Optimum processing order can be determined based on the intended purpose of the π-electron conjugated block copolymer.

In more detail, as shown in the following reaction formula (III), and in the presence of a catalyst and a compound A-X having a polymer block (A), M^{q2}-Z-M^{q2} and M^{q1}-Y-M^{q1} that are monomers of the polymer block (B) are reacted to bond a terminal of the polymer block (A) and the monomer of the polymer block (B) or the polymer block (B) through a coupling reaction during polymerization, obtaining the present π-electron conjugated block copolymer. Further, as shown in the following reaction formula (IV) and in the presence of a catalyst and a compound A-M^{p} having the polymer block (A), M^{q1}-Y-M^{q1} and M^{q2}-Z-M^{q2} that are monomers of the polymer block (B) are reacted, so that a terminal of the polymer block (A) and a monomer of the polymer block (B) or the polymer block (B) are bonded through a coupling reaction during polymerization, obtaining the π-electron conjugated block copolymer of the present invention.

Similarly, as shown in the reaction formula (III) and in the presence of compound B-X having the polymer block (B) and a catalyst, M^{q1}-Y-M^{q1} and M^{q2}-Z-M^{q2} that are monomers of the polymer block (A) are reacted to bond a terminal of the polymer block (B) and a monomer of the polymer block (A) or the polymer block (A) through coupling reaction during polymerization, obtaining the π-electron conjugated block copolymer of the present invention. In addition, as shown in the reaction formula (IV) and in the presence of a compound B-M^{p} having the polymer block (B) and a catalyst, M^{q1}-Y M^{q1} that is a monomer of the polymer block (A) and M^{q2}-Z-M^{q2} are reacted to bond a terminal of the polymer block (B) and the monomer of the polymer block (A) or the polymer block (A) through coupling reaction during polymerization, obtaining the π-electron conjugated block copolymer of the present invention.

Here, Y and Z represent the heteroaryl skeleton that constitute at least one part of the monomer unit of the π-electron conjugated block copolymer of the present invention, and are, for example, the heteroaryl skeleton having any one of groups represented by the formulas (1) - (17).

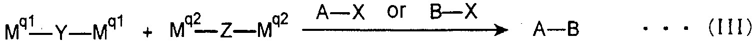

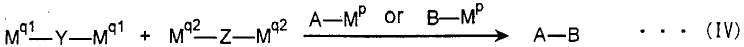

In reaction formulas (III) and (IV), A, B, X and M^{p} are the same meanings as defined above. M^{q1} and M^{q2} are not identical but are each independently a halogen atom, a boronic acid, a boronic acid ester, -MgX, -ZnX, -SiX₃ or -SnRa₃ (here, Ra is a linear alkyl group having 1 - 4 carbon atoms, and X is the same meaning as defined above). In other words, when M^{q1} is a halogen atom, M^{q2} is a boronic acid, a boronic acid ester, -MgX, -ZnX, -SiX₃ or -SnRa₃. On the contrary, if M^{q2} is a halogen atom, M^{q1} is a boronic acid, a boronic acid ester, -MgX, -ZnX, -SiX₃ or -SnRa₃. Y and Z represent a heteroaryl skeleton comprising at least one part of the monomer unit of the π-electron conjugated block copolymer of the present invention. A-B which is a product of the above reaction formula is a block copolymer including the copolymer of Y and Z.

A method for manufacturing the compound A-X or A-M^{p} having the polymer block (A) and the compound of B-X or B-M^{p} having the polymer block (B) will be explained. As shown in the following reaction formulas (V) and (VI) and in the presence of a catalyst, monomers M^{q1}-Y-M^{q1} and M^{q2}-Z-M^{q2} are reacted through a coupling reaction, to produce these compounds.

M^{q1}-Y-M^{q1} + M^{q2}-Z-M^{q2} → A-X or B-X (V)

M^{q1}-Y-M^{q1} + M^{q2}-Z-M^{q2} → A-M^{p} or B-M^{p} (VI)

When produced in such a method, X or M^{p} which is held in the compounds of A-X,

A-M^{p}, B-X and B-M^{p}, becomes a terminal functional group of the polymer block (A) or the polymer block (B), usually become functional groups derived from the monomer of M^{q1}-Y-M^{q1} and M^{q2}-Z-M^{q2}.

The polymer block (A) and the polymer block (B) can also be produced through a coupling reaction from a compound M^{q1}-Y-M^{q1}, a compound M^{q2}-Z-M^{q2} and a compound represented by a formula Ar-M^{r} (hereinafter, it may be called as an endcapping agent in some cases). Here, Ar is an aryl group. M^{r} represents M^{p} or X, and M^{p} and X are the same meanings as defined above. Such procedure, like the compound A-X or A-M^{p}, makes it easier to introduce a functional group that is used for coupling to only one terminal group.

X or M^{p} of the compound A-X, A-M^{p}, B-X and B-M^{p} may be a functional group derived from M^{q1}-Y-M^{q1} and M^{q2}-Z-M^{q2} which is a monomer of the polymer block (A) or the polymer block (B), or may be a functional group derived from the linker compound M^{r}-Q-M^{r} that is different from the monomer of the polymer block (A) or the polymer block (B). However, Q is an arylene group, M^{r} represents M^{p} or X, and M^{p} and X are the same meanings as defined above.

Q is preferably a monocyclic divalent arylene from the viewpoint of easy availability and reactivity, more preferably a divalent thiophene or benzene which may have a substituent. As specific examples, 2,5-dibromothiophene, 2,5-bis(trimethyltin)thiophene, 2,5-thiophenediboronic acid, 2,5-bis(3,3,4,4-tetramethyl-2,5,1-dioxaborolane-1-yl)thiophene, p-dibromobenzene, p-bis(trimethyltin)benzene, p-benzenedibronic acid, p-bis(3,3,4,4-tetramethyl-2,5,1-dioxaborolane-1-yl)benzene, etc. are exemplified.

When the compound A-X or A-M^{p}, the compound B-X or B-M^{p} is produced in accordance with the reaction formulas (V) and (VI), it is possible to introduce preferentially either M^{p} or X as the terminal functional group by excessively charging either monomer of M^{q1}-Y-M^{q1} or M^{q2}-Z-M^{q2}. However, since the polymerization does not proceed if either M^{q1}-Y-M^{q1} or M^{q2}-Z-M^{q2} is used too much, a molar ratio of M^{q1}-Y-M^{q1} to M^{q2}-Z-M^{q2} is preferable in the range of 0.5 - 1.5, and more preferably 0.7 -1.3.

In addition to the above method, at an early, middle or late stage of polymerization between monomer M^{q1}-Y-M^{q1} and monomer M^{q2}-Z-M^{q2}, it is possible to add an excessive amount of the linker compound M^{r}-Q-M^{r} to preferentially introduce the linker compound at the terminal of the polymer block (A) or the polymer block (B). The amount of the linker compound to be added is 1.5 times or more equivalent, preferably 2 times or more equivalent, more preferably 5 times or more equivalent of the terminal functional group calculated from a number average molecular weight (Mn) of the polymer block (A) or the polymer block (B) during polymerization.

A catalyst that is used in the manufacturing method mentioned above will be explained below. As the catalyst, a complex of a transition metal can be preferably used. Usually, a complex of a transition metal (group 3 - 10, especially group 8 - 10 of the periodic table, long form periodic table arranged according to 18 groups) are exemplified. Specifically, publicly known complexes of Ni, Pd, Ti, Zr, V, Cr, Co, Fe, etc. are exemplified. Among them, Ni and Pd complexes are more preferable. Further, as a ligand of the complex to be used, for example, a monodentate phosphine ligand such as trimethylphosphine, triethylphosphine, triisopropylphosphine, tri-t-butylphosphine, tricyclohexylphosphine, triphenylphosphine, tris(2-methylphenyl)phosphine, etc.; a bidentate phosphine ligand such as diphenylphosphino methane (dppm), 1,2-diphenylphosphino ethane (dppe), 1,3-diphenylphosphino propane (dppp), 1,4-diphenylphosphino butane (pddb), 1,3-bis(dicyclohexylphosphino)propane (dcpp), 1,1'-bis(diphenylphosphino)ferrocene (dppf), 2,2-dimethyl-1,3-bis(diphenylphosphino)propane, etc.; a nitrogen-containing ligand such as tetramethylethylenediamine, bipyridine, acetonitrile, etc. are preferably contained.

The amount of the catalyst to be used is based on the type of the π-electron conjugated block copolymer, but 0.001 - 0.1 mol for the monomer is preferably used. When the amount of catalyst is excessively used, molecular weight of the polymer becomes low and it is economically disadvantageous. On the other hand, the amount of catalyst to be added is too small, reaction rate becomes deteriorated, causing difficulty in stable production.

The present π-electron conjugated block copolymer is preferably prepared in the presence of solvent. The type of the solvent should be selectively used depending on the type of the π-electron conjugated block copolymer. However, generally available solvent can be selected and used. For example, an ether solvents such as tetrahydrofuran, 2-methyltetrahydrofuran, 1,4-dioxane, dimethyl ether, ethyl methyl ether, diethyl ether, dipropyl ether, butyl methyl ether, t-butyl methyl ether, dibutyl ether, cyclopentyl methyl ether, and diphenyl ether, etc.; aliphatic or alicyclic saturated hydrocarbon solvents such as pentane, hexane, heptane and cyclohexane, etc.; aromatic hydrocarbon solvents such as benzene, toluene, and xylene, etc.; alkyl halide solvents such as dichloromethane, chloroform, etc.; aromatic aryl halide solvents such as chlorobenzene, dichlorobenzene, etc.; amide solvents, such as dimethylformamide, diethyl formamide, N-methylpyrrolidone, etc.; water; and a mixture thereof, can be exemplified. The amount of the organic solvent to be used is preferably in the range of 1 - 1,000 times by weight for a monomer of the π-electron conjugated block copolymer, and preferably is 10 times by weight or more from the viewpoint of stirring efficiency of the reaction mixture and solubility of the bonded body. It is preferably in the range of 100 times or less by weight from the viewpoint of a reaction rate.

The polymerization temperature varies based on the type of the π-electron conjugated block copolymer. Usually, polymerization is carried out at temperature in the range of -80°C - 200°C. There is no specific limit for reaction pressure, but the pressure is preferably in the range of 0.1 - 10 atmospheric pressure. Generally, reaction is carried out at about 1 atmospheric pressure. The reaction time varies depending on the type of the π-electron conjugated block copolymer, but the reaction time is usually 20 minutes - 100 hours.

The π-electron conjugated block copolymer of the present invention can be obtained and separated from the reacted mixtures through, for example, conventional steps such as reprecipitation, removal of the solvent under heating, reduced pressure or steaming (steam stripping). These steps are usually processed to isolate the block copolymer from solution. The obtained crude product can be purified by extracting or washing with generally commercially available solvent using a Soxhlet extractor. For example, ether solvents such as tetrahydrofuran, 2-methyltetrahydrofuran, 1,4-dioxane, dimethyl ether, ethyl methyl ether, diethyl ether, dipropyl ether, butylmethyl ether, t-butyl methyl ether, dibutyl ether, cyclopentyl methyl ether, diphenyl ether and the like; aliphatic or alicyclic saturated hydrocarbon solvents such as pentane, hexane, heptane cyclohexane and the like; aromatic hydrocarbon solvents such as benzene, toluene, xylene, and the like; ketone solvents such as acetone, ethyl methyl ketone, diethyl ketone, and the like; halogenated alkyl solvents such as dichloromethane, chloroform, and the like; aromatic aryl halide solvents such as chlorobenzene and dichlorobenzene, and the like; amide solvents such as dimethylformamide, diethyl formamide, N-methylpyrrolidone, and the like; water; and a mixture thereof are exemplified.

The π-electron conjugated block copolymer of the present invention can be obtained and separated from the by-products through, for example, conventional steps such as reprecipitation, removal of the solvent under heating, reduced pressure or steaming (steam stripping). These steps are usually processed to isolate the block copolymer from the solution.

The present π-electron conjugated block copolymer mentioned above may have, as a terminal group, a coupling residue such as a halogen atom, a trialkyl tin group, a boronic acid group, a boronic acid ester group, or a desorbed hydrogen atom that are caught by the atoms or groups mentioned above. Further, these terminal groups may be terminal structures substituted with endcapping agents comprising aromatic boronic acid compounds or aromatic halides such as benzene bromides, etc.

As long as the effect of the present invention is not impaired, a homopolymer such as polymer block (A) and the polymer block (B) that are produced in the reaction mentioned above may be remained in the π-electron conjugated block copolymer. The amount of such residual components is preferably 70% or less.

The present π-electron conjugated block copolymer can be used in the photoelectric conversion active layer of the photoelectric conversion element by providing a composition containing an electron accepting material. As long as the organic material in the composition has n-type semiconductor characteristics, any electron accepting material can be used. For example, oxazole derivatives such as 1,4,5,8-naphthalenetetracarboxylic dianhydride (NTCDA), 3,4,9,10-perylene-tetracarboxylic-dianhydride (PTCDA), N,N'-dioctyl-3,4,9,10-naphthyl tetracarboxylic diimide (NTCDI-C8H), 2-(4-biphenylyl)-5-(4-t-butylphenyl)-1,3,4-oxadiazole, 2,5-di(1-naphthyl)-1,3,4-oxadiazole, etc.; triazole derivatives such as 3-(4-biphenylyl)-4-phenyl-5-(4-t-butylphenyl)-1,2,4-triazole, etc.; phenanthroline derivatives, fullerene derivatives such as C₆₀ or C₇₀; carbon nanotubes (CNT); derivatives (CN-PPV) obtained by introducing a cyano group into a poly-p-phenylenevinylene polymers, etc. are exemplified. These may be used alone respectively or used by mixing two or more thereof. Among them, the fullerene derivatives are preferably used, from the viewpoint that these n-type semiconductors have an excellent carrier mobility and stability.

As fullerene derivatives preferably used in the present invention as an electron accepting organic semiconductor, for example; non-substituted ones such as C₆₀, C₇₀, C₇₆, C₇₈, C₈₂, C₈₄, C₉₀ and C₉₄; and substituted ones such as [6,6]-phenyl C₆₁ butyric acid methyl ester ([6,6]-C₆₁-PCBM), [5,6]-phenyl C₆₁ butyric acid methyl ester, [6,6]-phenyl C₆₁ butyric acid n-butyl ester, [6,6]-phenyl C₆₁ butyric acid i-butyl ester, [6,6]-phenyl C₆₁ butyric acid hexyl ester, [6,6]-phenyl C₆₁ butyric acid dodecyl ester, [6,6]-diphenyl C₆₂ bis(butyric acid methyl ester) ([6,6]-C₆₂-bis-PCBM), [6,6]-phenyl C₇₁ butyric acid methyl ester ([6,6]-C₇₁-PCBM); etc. are exemplified.

The fullerene derivatives mentioned above can be used alone or as a mixture thereof, but from the viewpoint of solubility in organic solvents, [6,6]-C₆₁-PCBM, [6,6]-C₆₂-bis-PCBM, [6,6]-C₇₁-PCBM are preferably used.

A photoelectric conversion element of the present invention comprises an organic photoelectric conversion layer which is provided from the composition comprising the π-electron conjugated block copolymer and electron accepting materials, and is capable of generating electricity due to function of the layer provided from the composition.

As long as the objects of the present invention are not impaired, the composition of the present invention may include other components such as surface active agents, binder resins, filler, etc.

The rate of the electron accepting material in the composition is in the range of 10 - 1,000 parts by weight against 100 parts by weight of the π-electron conjugated block copolymer, more preferably 50 - 500 parts by weight.

A mixing method of the π-electron conjugated block copolymer and the electron accepting material is not particularly limited, but after the addition of a solvent in a desired ratio, the mixture is subjected to one or more processes including processes of heating, stirring, ultrasonic irradiation, etc. to dissolve them into the solvent, is exemplified.

The solvent to be used is not specifically limited, but the solvent should be selected from the viewpoint of solubility each of the π-electron conjugated block copolymer and the electron accepting material at 20°C. From the viewpoint of forming the organic thin film, preferable solubility at 20°C is 1 mg/mL or more. When solubility is less than 1 mg/mL, it is difficult to produce homogeneous organic thin film, accordingly it is impossible to obtain the composition of the present invention. Furthermore, from the viewpoint of arbitrarily controlling the film thickness of the organic thin film, a solvent having the solubility of 3 mg/mL or more at 20°C for each of the π-electron conjugated block copolymer and the electron accepting material, is preferably used. Further, the boiling points of these solvents are preferably from the viewpoint of the manufacturing process in the range of room temperature to 200°C.

As such solvents, for example, tetrahydrofuran, 1,2-dichloroethane, cyclohexane, chloroform, bromoform, benzene, toluene, o-xylene, chlorobenzene, bromobenzene, iodobenzene, o-dichlorobenzene, anisole, methoxybenzene, trichlorobenzene, pyridine, and the like are exemplified. These solvents may be used alone or may be used by mixing two or more. Especially in view of the high solubility of the π-electron conjugated block copolymer and of the electron accepting material, o-dichlorobenzene, chlorobenzene, bromobenzene, iodobenzene, chloroform, and the mixtures of them are preferably used. More preferably, o-dichlorobenzene, chlorobenzene, or the mixtures thereof are used.

In addition to the π-electron conjugated block copolymer and the electron accepting material, additives having a boiling point higher than that of the solvent may be added into the solution described above. By the presence of the additives, fine and continuous phase-separated structure of the π-electron conjugated block copolymer and the electron accepting material can be formed during the forming process of the organic thin film. Accordingly, it is possible to obtain an active layer having excellent photoelectric conversion efficiency. As the additives, octanedithiol (boiling point: 270°C), dibromooctane (boiling point: 272°C), diiodooctane (boiling point: 327°C) and the like are exemplified.

The amount of the additives to be added is not particularly limited as long as both the π-electron conjugated block copolymer and the electron accepting material are not deposited and a homogeneous solution is given. However, the amount of addition is preferably in the range of 0.1 - 20% by volume of the solvent. When additives are added in less than 0.1%, it is impossible to obtain a sufficient effect in continuous fine phase separation structure, on the contrary when more than 20%, drying rate becomes slow, so that it is difficult to obtain a homogeneous organic thin film. More preferably, the amount of additives is in the range of 0.5% - 10%.

The thickness of the organic photoelectric conversion layer is usually in the range of 1 nm - 1 µm, preferably in the range of 2 nm - 1,000 nm, more preferably 5 nm - 500 nm, still more preferably 20 nm - 300 nm. Light is not sufficiently absorbed if the film thickness is too thin. The carrier does not easily reach to an electrode if the film is too thick on the contrary.

A coating method of the solution containing the π-electron conjugated block copolymer and the electron accepting material, on a substrate or a support is not particularly limited. Any conventional coating methods using liquid type coating materials can be employed. For example, any coating method such as a dip coating method, a spray coating method, an ink jet method, an aerosol jet method, a spin coating method, a bead coating method, a wire bar coating method, a blade coating method, a roller coating method, a curtain coating method, a slit die coater method, a gravure coater method, a slit reverse coater method, a micro gravure method, and a comma coater method, etc. can be employed depending on the coating characteristics such as alignment control, coating thickness, etc.

The organic photoelectric conversion layer may be additionally subjected to thermal annealing, if necessary. The thermal annealing of an organic thin film on the substrate is performed by holding the desired temperature. The thermal annealing may be performed under an inert gas atmosphere or under reduced pressure. Preferred temperature is 40°C - 300°C, more preferably, 70°C - 200°C. Sufficient effect is not obtained when the temperature is low. When temperature is too high, oxidation and/or degradation occurs in the organic thin film, so that sufficient photoelectric conversion characteristics are not obtained.

The substrates on which the photoelectric conversion element of the present invention are formed, may be any film or plate which does not change when forming the organic photoelectric conversion layer and electrodes. For example, inorganic material such as non-alkali glass or quartz glass, metal film such as aluminum, organic material such as polyester, polycarbonate, polyolefin, polyamide, polyimide, polyphenylene sulfide, polyparaxylene, epoxy resin, fluorine resin, etc. can be used. In the case of using an opaque substrate, the opposite electrode (i.e., the electrode that is located far from the substrate) that is transparent or semi-transparent is preferably used. The thickness of the substrate is not particularly limited, but is usually in the range of 1 µm - 10 mm.

Light-permeability is necessary for either one of positive or negative electrode of the photovoltaic element of the present invention. As long as incident light reaches to the organic photoelectric conversion layer and generates the electromotive forces, the light transmittance of the electrode is not particularly limited. The thickness of the electrode is depending on electrode materials, but is not particularly limited. However preferably in the range of 20 nm - 300 nm as long as the electrode is electrically conductive and optically transparent. The optical transparency is not specifically required for the other electrode as long as the other electrode is electrically conductive. The thickness thereof is not particularly limited.

As the positive electrode which is included in the photoelectric conversion element of the present invention, metals such as lithium, magnesium, calcium, tin, gold, platinum, silver, copper, chromium, nickel etc. are preferably used. As a transparent electrode, metal oxide such as indium, tin, etc., a complex metal oxide such as indium tin oxide (ITO), indium zinc oxide (IZO), fluorine-doped tin oxide (FTO), etc. are preferably used. A grid electrode in which metal is formed into a transparent mesh-like electrode, transparent electroconductive organic film made from such as polyaniline and its derivatives, polythiophene and its derivatives may also be used. As a manufacturing method of the positive electrode, for example, a vacuum deposition method, a sputtering method, an ion plating method, a metal plating method and the like can be exemplified. The positive electrode can also be manufactured by coating method using metal ink, metal paste, low melting point metal, organic conductive ink, etc.

An increase in an output current can be realized by introducing, between the organic photoelectric conversion layer and the negative electrode, metal fluoride such as lithium fluoride, sodium fluoride, potassium fluoride, magnesium fluoride, calcium fluoride, or cesium fluoride. More preferably, lithium fluoride or cesium fluoride is introduced.

In the photoelectric conversion element of the present invention, a hole transporting layer may be provided between the organic photoelectric conversion layer and the cathode if necessary. As a material for forming the hole transporting layer is not particularly limited as long as it has a p-type semiconductor properties. Conductive polymers such as polythiophene containing polymer, polyaniline containing polymer, poly-p-phenylenevinylene containing polymer, polyfluorene containing polymer, etc.; low molecular weight organic compounds having p-type semiconductor characteristics such as phthalocyanine (Pc), phthalocyanine derivatives (such as copper phthalocyanine, zinc phthalocyanine, etc.), porphyrin derivatives, etc.; metal oxides such as molybdenum oxide, zinc oxide, vanadium oxide, etc. are preferably used. The thickness of the hole transporting layer is preferably in the range of 1 nm - 600 nm, more preferably 20 nm - 300 nm.

In the photoelectric conversion element of the present invention, an electron transporting layer may be provided between the active layer and the negative electrode if necessary. A material for forming the electron transporting layer is not particularly limited as long as it has n-type semiconductor characteristics. The electron accepting organic material described above, for example, NTCDA, PTCDA, NTCDI-C8H, oxazole derivatives, triazole derivatives, phenanthroline derivatives, fluorene derivatives, CNT, CN-PPV, etc. are preferably used. The thickness of the electron transporting layer is preferably in the range of 1 - 600 nm, more preferably 5 - 100 nm.

When providing a hole transporting layer between the active layer and the positive electrode using the conductive polymer that is soluble in a solvent, a coating or applying method such as a dip coating method, a spray coating method, an inkjet method, an aerosol jet method, a spin coating method, a bead coating method, a wire bar coating method, a blade coating method, a roller coating method, a curtain coating method, a slit die coater method, a gravure coater method, a slit reverse coater method, a micro gravure method, a comma coater method, etc., can be used. When using a low molecular weight organic material such as porphyrin derivatives or phthalocyanine derivatives, a deposition method using a vacuum deposition device can be preferably used. The electron transporting layer can also be produced in the same manner as described above.

The photoelectric conversion element of the present invention is applicable to various photoelectric conversion devices having photoelectric conversion function and optical rectification function, etc. For example, the photoelectric conversion elements can be used for photovoltaic cells (such as solar cells, etc.), electric devices (such as light sensors, light switches, photo transistors, etc.), and optical recording materials (such as optical memories, etc.).

### EMBODIMENTS

Examples of the present invention are described in detail, but the scope of the present invention is not limited to these examples.

Measurement of physical properties and purification methods of the materials produced in the respective steps described above and in the following steps, were carried out as follows.

### [Weight Average Molecular Weight (Mw), Number Average Molecular Weight (Mn)]

The number average molecular weight and the weight average molecular weight were represented in terms of polystyrene-converted value based on the measurement of gel permeation chromatography (GPC) using a GPC apparatus (HLC-8020, trade name, produced by Tosoh Corporation) with two columns connected in series (TSKgel Multipore HZ, trade name, produced by Tosoh Corporation). Measurements were carried out using chloroform as solvent, and at 40°C measured at its column and an injector.

The measurements of the weight average molecular weight (Mw) and the number average molecular weight (Mn) of Polymerization Examples 5, 8 and 9 and Examples 5 - 9, 10 - 13 were carried out using a GPC apparatus (GPC/V2000, trade name produced by Waters Co.) Two columns (Shodex AT-G806MS, trade name produced by Showa Denko K.K.) were connected in series and used. The temperatures measured in the column and an injector were 145°C. O-dichlorobenzene was used as solvent.

### [Purification of Polymers]

Purification of the obtained polymers was carried out using a preparative GPC column (Recycling Preparative HPLC LC-908 produced by Japan Analytical Industry Co., Ltd.). Two styrene-containing polymer columns (2H-40 and 2.5H-40, produced by Japan Analytical Industry Co., Ltd.) were connected in series (elution solvent: chloroform).

### [¹H-NMR Measurement]

¹H-NMR measurement was carried out using NMR spectrometer (JEOL JNM-EX270 FT produced by JEOL Ltd.). Unless otherwise indicated, ¹H-NMR measurement was carried out at room temperature and at 270 MHz with chloroform (CDCl₃).

Note that the meaning of the abbreviations used in this invention is that EtHex and HexEt represent 2-ethylhexyl group, and 3-Hep represents 3-heptyl group.

### [Synthesis Example 1]

A monomer represented by the following formula (i) was synthesized.

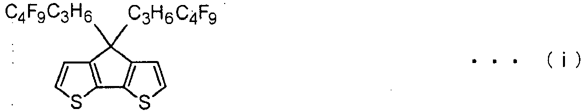

Under a nitrogen atmosphere, cyclopenta[2,1-b:3,4-b']dithiophene (0.36 g, 2.0 mmol) and tetrahydrofuran (30 mL) were charged into a 100 mL three-necked flask and cooled to below 0°C. Then 1.6M solution n-butyl lithium in hexane (1.38 mL, 2.2 mmol) was slowly added dropwise, followed by stirring for 1 hour after the temperature was raised to room temperature. After the temperature was cooled down again to 0°C, 1-iodine-4,4,5,5,6,6,7,7,7-nonafluoroheptane (0.64 g, 2.0 mmol) was added, followed by stirring for 1 hour. Then 1.6M solution n-butyl lithium in hexane (1.38 mL, 2.2 mmol) was slowly added dropwise. After the temperature was raised to room temperature, stirring was continued for 1 hour. The temperature was cooled down below 0°C. Then 1-iodine-4,4,5,5,6,6,7,7,7-nonafluoroheptane (0.64 g, 2.0 mmol) was added, followed by stirring for 1 hour. After completion of the reaction, the reacted mixture was poured into saturated brine (100mL) and extracted with ethyl acetate (30 mL × 3), washed with water (30mL × 3). The resulting organic layer was dried over sodium sulfate and then solvent was evaporated under reduced pressure.

The obtained crude product was purified using silica gel column chromatography (hexane), obtaining a pale yellow solid of 4,4-bis(4,4,5,5,6,6,7,7,7-nonafluoroheptyl)cyclopenta[2,1-b:3,4-b']dithiophene (1.06 g, 69%) which is represented by the formula (i).
¹H-NMR (270 MHz, CDCl₃): δ = 7.21 (d, J = 2.7 Hz, 1H), 6.92 (d, J = 2.7 Hz, 1H), 2.00 - 1.97 (m, 4H), 1.87 - 1.84 (m, 4H), 1.26 - 1.19 (m, 4H)

### [Synthesis Example 2]

A monomer represented by the following formula (ii) was synthesized.

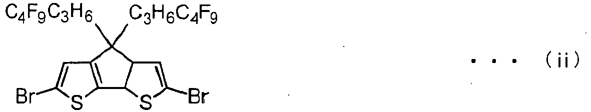

Under a nitrogen atmosphere, the compound (1.06 g, 1.38 mmol) represented by formula (i) and tetrahydrofuran (13 mL) were charged into a 100 mL three-necked flask, and then cooled to below 0°C. Then, N-bromosuccinimide (0.49 g, 2.76 mmol) was added slowly, followed by stirring for 1 hour at below 0°C. The temperature was raised to room temperature. After the completion of the reaction, the reacted mixture was poured into saturated brine (100 mL), then extracted with hexane (30 mL × 3), then washed with water (30 mL × 3). The obtained organic layer was dried over sodium sulfate, then the solvent was evaporated under reduced pressure, obtaining a crude product that was purified using silica gel column chromatography (hexane) to obtain an yellow solid of 2,6-dibromo-4,4-bis(4,4,5,5,6,6,7,7,7-nonafluoroheptyl)cyclopenta[2,1-b:3,4-b']dithio phene (0.99 g, 77%) that is represented by the formula (ii).
¹H-NMR (270 MHz, CDCl₃): δ = 6.94 (s, 2H), 1.96 - 1.80 (m, 8H), 1.54 - 1.51 (m, 4H), 1.27 - 1.15(m, 4H)

### [Synthesis Example 3]

A monomer represented by the following formula (iii) was synthesized. 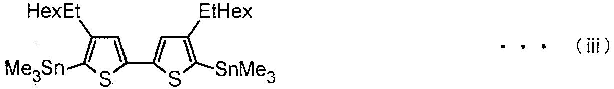 4,4'-di(2-ethylhexyl)-5,5'-ditrimethyltin-2,2'-bithiophene which is represented by the formula (iii) was synthesized according to a method described in Adv. Mater., 19, p.4160 (2007) from 3-bromothiophene and 2-ethylhexyl bromide as starting materials. ¹H-NMR: δ = 7.10 (s, 2H), 2.41 (d, J = 7.0 Hz, 4H), 1.40 - 1.08 (m, 18H), 0.89 (t, J = 3.4 Hz, 12), 0.40 (s, 18H)

Synthesis methods of monomers from which other polymer blocks described below are synthesized, are described, for example, in the documents listed below.

Adv. Funct. Mater., 19, p.1 (2009), J. Am. Chem. Soc., 130, p.16145 (2008), Organometallics, 30, p.3233 (2011), Adv. Mater., 21, p.209 (2009), J. Am. Chem. Soc., 131, p.7792 (2009), WO2010/135701 Angew. Chem. Int. Ed., 50, p.1 (2011), J. Am. Chem. Soc., 133, p.4250 (2011), Macromolecules, 43, p.6936 (2010)

### [Polymerization Example 1]

A polymer block (A1) was synthesized according to the reaction formula below.

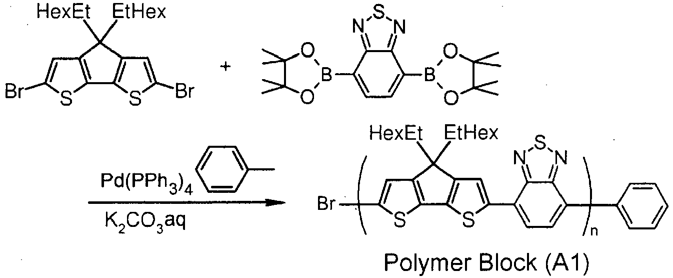

Under a nitrogen atmosphere, in a 100 mL three-necked flask, 4,7-bis(3,3,4,4-tetramethyl-2,5,1-dioxaborolane-1-yl)benzo[c][1,2,5]thiadiazole (1.04 g, 2.68 mmol) and 2,6-dibromo-4,4'-bis(2-ethylhexyl)cyclopenta[2,1-b:3,4-b']dithiophene (1.50 g, 2.68 mmol), which were monomers that would constitute the polymer block (A1), were added, and, further, toluene (50 mL), 2M aqueous solution of potassium carbonate (25 mL, 50 mmol), tetrakis(triphenylphosphine)palladium(0) (61.9 mg, 53.5 µmol) and aliquat 336 (2 mg, 4.95 µmol) were added. The mixture was stirred for 2 hours at 80°C. After that, Phenyl bromide (0.21 g, 1.34 mmol) was added as an endcapping agent, and stirred for 18 hours at 80°C. After completion of the reaction, the reacted solution was poured in methanol (500 mL), to obtain a solid that was collected by filtration, washed with water (100 mL) and methanol (100 mL). The obtained solid was dried under reduced pressure, obtaining a crude product. After washed with acetone (200 mL), hexane (200 mL), the crude product was extracted with chloroform (200 mL) using a Soxhlet extractor. The resulting solution was concentrated, then poured into methanol (500 mL) to precipitate a solid that was collected by filtration and then dried under reduced pressure, obtaining the polymer block (A1) (1.06 g, 74%), as a black purple solid. The weight average molecular weight (Mw) and the number average molecular weight (Mn) of the obtained polymer block (A1) were each 44,300 and 20,100. The polydispersity thereof was 2.20.
¹H-NMR (270 MHz): δ = 8.10 - 7.96 (m, 2H), 7.81 - 7.61 (m, 2H), 2.35 - 2.13 (m, 4H), 1.59 - 1.32 (m, 18H), 1.18 - 0.81 (m, 12H)

### [Polymerization Example 2]

A polymer block (B1) was synthesized according to the reaction formula below.

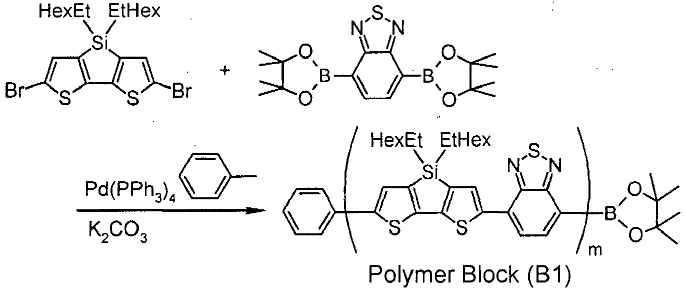

The polymer block (B1) (0.93 g, 63%) was obtained in the same manner as described in Polymerization Example 1, except that 2,6-dibromo-4,4'-bis(2-ethylhexyl)dithieno[3,2-b:2',3'-d]silole (1.55 g, 2.68 mmol) and 4,7-bis(3,3,4,4-tetramethyl-2,5,1-dioxaborolane-1-yl)benzo[c][1,2,5]thiadiazole (1.04 g, 2.68 mmol), which were monomers that would constitute the polymer block (B1), and as an endcapping agent phenylboronic acid pinacol ester (0.27 g, 1.34 mmol), were used. The weight average molecular weight (Mw) and the number average molecular weight (Mn) of the obtained polymer block (B1) were each 42,400 and 17,500. And the polydispersity thereof was 2.42.
¹H-NMR (270 MHz): δ = 8.20 - 7.95 (m, 2H), 7.92 - 7.20 (m, 2H), 2.34 - 2.10 (m, 4H), 1.59 - 1.33 (m, 18H), 1.19 - 0.81 (m, 12H)

### [Synthesis Example 3]

A polymer block (B3) was synthesized according to the reaction formula below.

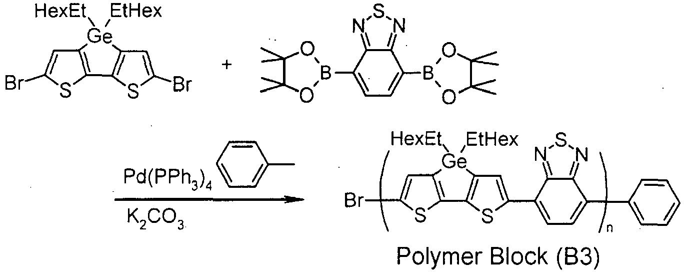

The polymer block (B3) (1.03 g, 64%) was obtained in the same manner as described in Polymerization Example 1, except that 2,6-dibromo-4,4'-bis(2=ethylhexyl)dithieno[3,2-b:2',3'-d]germole (1.66 g, 2.68 mmol) and 4,7-bis(3,3,4,4-tetramethyl-2,5,1-dioxaborolane-1-yl)benzo[c][1,2,5]thiadiazole (1.04 g, 2.68 mmol), which were monomers that would constitute the polymer block (B3), were used. The weight average molecular weight (Mw) and the number average molecular weight (Mn) of the polymer block (B3) were each 43,200 and 18,300. And the polydispersity thereof was 2.36.
¹H-NMR (270 MHz): δ = 8.20 - 7.95 (m, 2H), 7.90 - 7.12 (m, 2H), 2.34 - 2.10 (m, 4H), 1.59 - 1.33 (m, 18H), 1.19 - 0.81 (m, 12H)

### [Polymerization Example 4]

A polymer block (A2) was synthesized according to the reaction formula below.

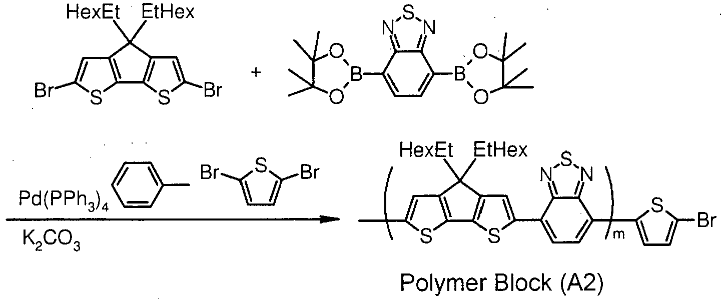

Under a nitrogen atmosphere, into a 100 mL three-necked flask, 2,6-dibromo-4,4'-bis(2-ethylhexyl)cyclopenta[2,1-b:3,4-b']dithiophene (1.50 g, 2.68 mmol) and 4,7-bis(3,3,4,4-tetramethyl-2,5,1-dioxaborolane-1-yl)benzo[c][1,2,5]thiadiazole (1.08 g, 2.68 mmol), which were monomers that would constitute the polymer block (A2), were added. And further toluene (50 mL), 2M aqueous solution of potassium carbonate (25 ml, 50 mmol), tetrakis(triphenylphosphine)palladium(0) (62.0 mg, 54.0 µmol) and aliquat 336 (2 mg, 4.95 µmol) were added, and then the mixture was stirred for 1 hour at 80°C. After that, 2,5-dibromothiophene (6.47 g, 26.8 mmol) was added as a linker compound and stirring was continued for 16 hours at 80°C. After completion of the reaction, the reacted mixture was poured into methanol (500 mL). The precipitated solid was collected by filtration, washed with water (100 mL) and methanol (100 mL), then dried under reduced pressure, obtaining a crude product. The crude product was washed with acetone (200 mL) and hexane (200 mL), then extracted with chloroform (200 mL) using a Soxhlet extractor. The organic layer was concentrated to obtain a dried solid. The obtained black purple solid was dissolved in chloroform (30 mL) and then poured into methanol (300 mL) to reprecipitate. The obtained solid was collected by filtration and dried under reduced pressure, obtaining the polymer block (A2) (1.24 g, 87%) as a black purple solid. The weight average molecular weight (Mw) and the number average molecular weight (Mn) of the obtained polymer block (A2) were each 52,000 and 23,100. The polydispersity thereof was 2.25.
¹H-NMR (270 MHz): δ= 8.10 - 7.95 (m, 2H), 7.80 - 7.61 (m, 2H), 2.35 - 2.12 (m, 4H), 1.60 -1.32 (m, 18H), 1.18 - 0.82 (m, 12H)

### [Polymerization Example 5]

A polymer block (A3) was synthesized according to the reaction formula below.

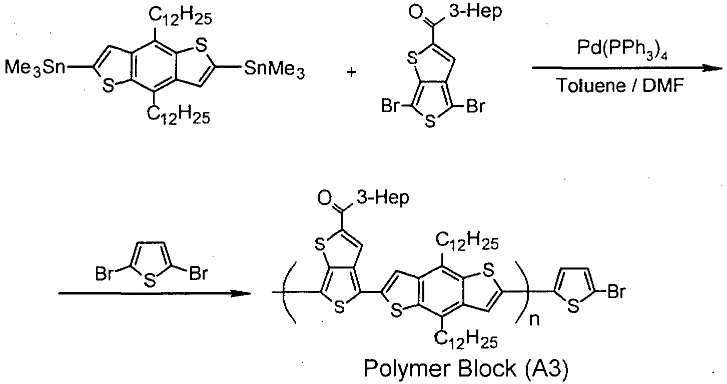

Under a nitrogen atmosphere, into a 50 mL eggplant flask, 2,6-bis(trimethyltin)-4,8-didodecylbenzo[1,2-b:4,5-b']dithiophene (0.64 g, 0.75 mmol) and 1-(4,6-dibromothieno[3,4-b]thiophene-2-yl)-2-ethylhexane-1-one (0.32 g, 0.75 mmol), which were monomers that would constitute the polymer block (A3), were added. And further DMF (6.2 mL), toluene (25 mL) and tetrakis(triphenylphosphine)palladium(0) (9.2 mg, 7.8 µmol) were added, and then the mixture was heated for 1.5 hours at 115°C. Next, 2,5-dibromothiophene (1.84 g, 7.6 mmol) was added as a linker compound and heating was continued for 16 hours at 115°C. After completion of the reaction, the reacted mixture was concentrated and poured into methanol (500 mL). The precipitated solid was collected by filtration and then the obtained solid was dried under reduced pressure, obtaining a crude product. The crude product was washed with acetone (200 mL) and hexane (200 mL), then extracted with chloroform (200 mL) using a Soxhlet extractor. The organic layer was concentrated to obtain a dried solid. The obtained black purple solid was dissolved in chloroform (30 mL) and then poured into methanol (300 mL) to reprecipitate. The obtained solid was collected by filtration, dried under reduced pressure, obtaining the polymer block (A3) (0.51 g, 86%) as a black purple solid. The weight average molecular weight (Mw) and the number average molecular weight (Mn) of the obtained polymer block (A3) were each 33,100 and 14,600. The polydispersity thereof was 2.27.
¹H-NMR (270 MHz): δ = 7.60 - 7.30 (br, 3H), 3.30 - 3.00 (Br, 5H), 2.00 - 1.10 (br, 52H), 1.00 - 0.70 (br, 12H)

### [Polymerization Example 6]

A polymer block (A4) was synthesized according to the reaction formula below.

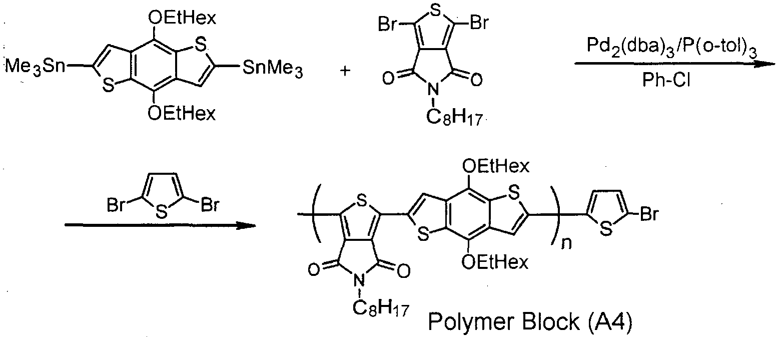

Under a nitrogen atmosphere, in a 50 mL eggplant flask, tris(o-tolyl)phosphine (37 mg, 0.12 mmol), tris(dibenzylideneacetone)dipalladium (14 mg, 15 µmol) and chlorobenzene (32 mL) were added then heated for 10 minutes at 50°C. After heating, the temperature once cooled down to room temperature, then 2,6-bis(trimethyltin)-4,8-diethylhexyloxybenzo[1,2-b:4,5-b']dithiophene (0.64 g, 0.75 mmol) and 1,3-dibromo-5-octylthieno[3,4-c]pyrrole-4,6-dione (0.32 g, 0.75 mmol) were added and heated for 3 hours at 130°C. After that, the polymer block (A4) (0.51 g, 96%) was obtained using the same manner as described in Polymerization Example 5. The weight average molecular weight and the number average molecular weight of the obtained polymer block (A4) were each 250,000 and 52,000. The polydispersity thereof was 4.80.
¹H-NMR (270 MHz): δ = 8.52 (br, 2H), 4.65 - 3.66 (br, 4H), 3.58 (s, 2H), 1.38 - 1.25 (m, 30H), 0.97 - 0.90 (br, 15H)

### [Polymerization Example 7]

A polymer block (A5) was synthesized according to the reaction formula below.

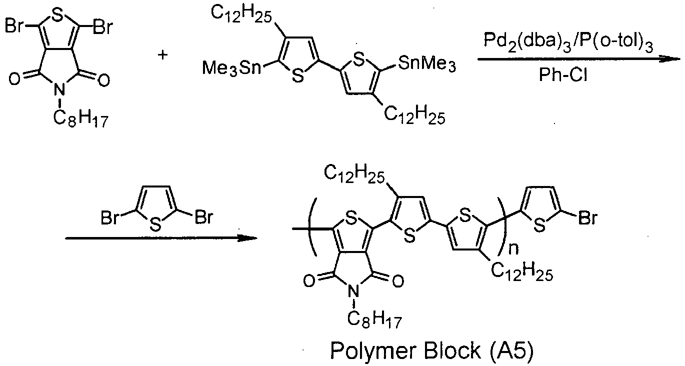

The polymer block (A5) (0.46 g, 80%) was obtained in the same manner as described in Polymerization Example 6, except that 1,3-dibromo-5-ethylhexylthieno[3,4-c]pyrrole-4,6-dione (0.32 g, 0.75 mmol) and 4,4'-didodecyl-5,5'-trimethyltin-2,2'-bithiophene (0.62 g, 0.75 mmol), which were monomers that would constitute the polymer block (A5), were used. The weight average molecular weight (Mw) and the number average molecular weight (Mn) of the polymer block (A5) were each 210,000 and 48,000. And the polydispersity thereof was 4.38.
¹H-NMR (270 MHz): δ = 7.17 (s, 2H), 3.56 (br, 2H), 2.84 - 2.81 (br, 4H), 1.88 (br, 1H), 1.73 - 1:66 (br, 4H), 1.49 - 1.27 (br, 44H), 0.95 - 0.86 (br, 12H)

### [Polymerization Example 8]

A polymer block (A6) was synthesized according to the reaction formula below.

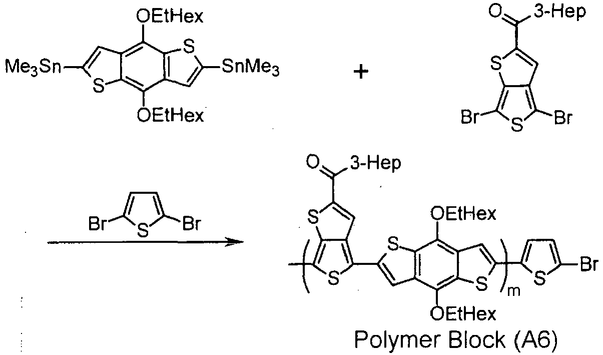

Under a nitrogen atmosphere, in a 50 mL eggplant flask, 2,6-bis(trimethyltin)-4,8-bis(2-ethylhexyloxy)benzo[1,2-b:4,5-b']dithiophene (0.66 g, 0.86 mmol) and 1-(4,6-dibromothieno[3,4-b]thiophene-2-yl)-2-ethylhexane-1-one (0.32 g, 0.75 mmol), which were monomers that would constitute the polymer block (A6), DMF (1.1 mL), toluene (4.3 mL), tetrakis(triphenylphosphine)palladium(0) (9.2 mg, 7.8 µmol) were added and heated for 1.5 hours at 115°C. Next, 2,5-dibromothiophene (1.84 g, 7.6 mmol) was added as a linker compound and heated for 8 hours at 115°C. After completion of the reaction, the reacted mixture was poured into methanol (500 mL). The precipitated solid was collected by filtration and dried under reduced pressure, obtaining a crude product. The crude product was washed with acetone (200 mL) and hexane (200 mL), then extracted with chloroform (200 mL) using a Soxhlet extractor. The organic layer was concentrated to obtain a dried black purple solid that was then dissolved in chloroform (30 mL) which was poured and reprecipitated in methanol (300 mL). The obtained solid was collected by filtration and dried under reduced pressure, obtaining the polymer block (A6) (0.53 g, quant.) as a black purple solid. The weight average molecular weight (Mw) and the number average molecular weight (Mn) of the obtained polymer block (A6) were each 58,000 and 33,000. The polydispersity thereof was 1.76.
¹H-NMR (270 MHz, CDCl₃): δ = 7.60 - 7.30 (br, 3H), 4.30 - 4.00 (br, 4H), 3.20 - 3.00 (Br, 1 H), 2.00 - 0.60 (br, 44H)

### [Polymerization Example 9]

A polymer block (A7) was synthesized according to the reaction formula below.

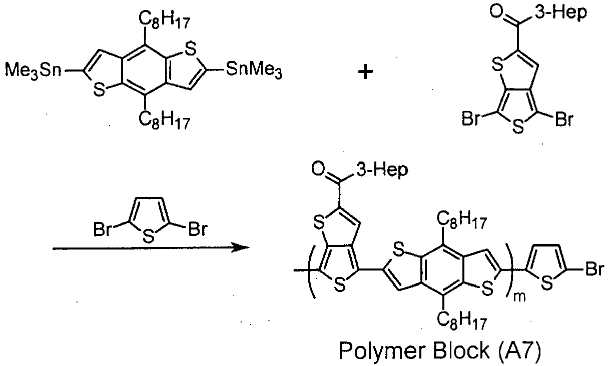

The polymer block (A7) (0.47 g, 93%) was obtained in the same manner as described in Polymerization Example 8, except that 2,6-bis(trimethyltin)-4,8-dioctylbenzo[1,2-b:4,5-b']dithiophene (0.59 g, 0.79 mmol) and 1-(4,6-dibromothieno[3,4-b]thiophene-2-yl)-2-ethylhexane-1-one (0.32 g, 0.75 mmol), which were monomers that would constitute the polymer block (A7), were used. The weight average molecular weight (Mw) and the number average molecular weight (Mn) of the obtained polymer block (A7) were each 64,300 and 23,600. And the polydispersity thereof was 2.7.
¹H-NMR (270 MHz, CDCl₃): δ = 7.60 - 7.30 (br, 3H), 3.30 - 0.30 (br, 5H), 2.00 - 1.20 (br, 32H), 1.00 - 0.70 (br, 12H)

### [Example 1]

A block copolymer (1) was synthesized according to the reaction formula below.

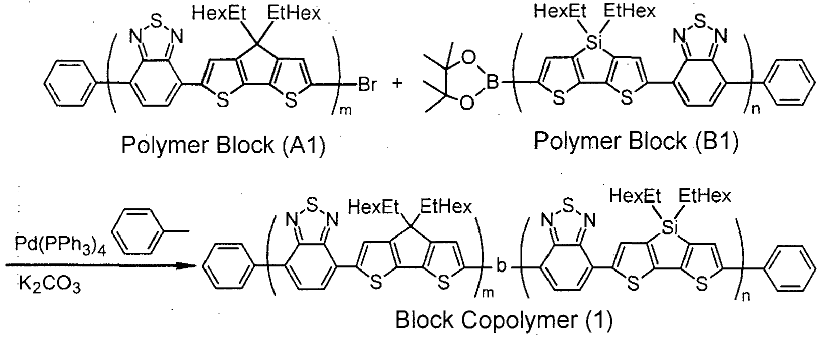

Under a nitrogen atmosphere, in a 100 mL three-necked flask, the polymer block (A1) (0.80 g, 1.5 mmol), the polymer block (B1) (0.83 g, 1.5 mmol) were added, and toluene (20 mL), 2M aqueous solution of potassium carbonate (10 mL, 20 mmol), tetrakis (triphenylphosphine) palladium (0) (20.5 mg, 17.7 µmol) and aliquat 336 (0.8 mg, 1.98 µmol) were added then stirred for 24 hours at 80°C. After completion of the reaction, the reacted mixture was poured into methanol (200 mL). The precipitated solid was collected by filtration, washed with water (20 mL) and methanol (20 mL). The obtained solid was dried under reduced pressure, obtaining a crude product. The crude product was washed with acetone (100 mL) and hexane (100 mL), and then extracted with chloroform (100 mL) using a Soxhlet extractor. The obtained solution was poured into methanol (1 L). The precipitated solid was collected by filtration, then dried under reduced pressure, obtaining the block copolymer (1) (0.51 g, 31 %) as a black purple solid. The weight average molecular weight (Mw) and the number average molecular weight (Mn) of the obtained block copolymer (1) were each 85,200 and 40,800. The polydispersity thereof was 2.09.
¹H-NMR (270 MHz): δ =8.13 - 7.93 (m, 4H), 7.81 - 7.62 (m, 4H), 2.36 - 2.11 (m, 8H), 1.63 - 1.30 (m, 36H), 1.20 - 0 .84 (m, 24H)

### [Example 2]

A block copolymer (2) was synthesized according to the reaction formula below.

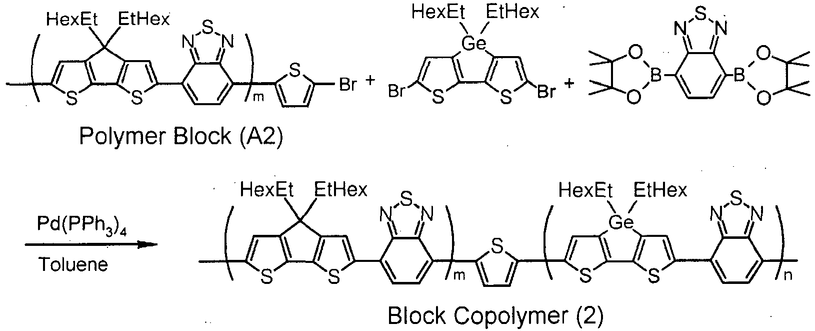

Under a nitrogen atmosphere, in a 25 mL three-necked flask, the polymer block (A2) (0.50 g, 0.94 mmol), 2,6-dibromo-4,4'-bis(2-ethylhexyl)dithieno[3,2-b:2',3'-d]germole (0.58 g, 0.91 mmol) and 4,7-bis(3,3,4,4-tetramethyl-2,5,1-dioxaborolane-1-yl)benzo[c][1,2,5]thiadiazole (0.36 g, 0.94 mmol) which were monomers that would constitute the polymer block (B) were added, and toluene (20 mL), 2M aqueous solution of potassium carbonate (10 mL, 20 mmol), tetrakis(triphenylphosphine)palladium(0) (20.5 mg, 17.7 µmol) and aliquat 336 (0.8 mg, 1.98 µmol) were added then stirred for 16 hours at 80°C. After completion of the reaction, the reacted mixture was poured into methanol (200 mL). The precipitated solid was collected by filtration, washed with water (20 mL) and methanol (20 mL). The obtained solid was dried under reduced pressure, obtaining a crude product. The crude product was washed with acetone (200 mL) and hexane (200 mL), and then extracted with chloroform (200 mL) using a Soxhlet extractor. The organic layer was concentrated to obtain a dried black purple solid. It was dissolved in chloroform (30 mL), and then was poured in methanol (300 mL) to reprecipitate the solid. The obtained solid was collected by filtration, then dried under reduced pressure, obtaining the block copolymer (2) (0.41 g, 76%) as a black purple solid. The weight average molecular weight (Mw) and the number average molecular weight (Mn) of the obtained block copolymer (2) were each 76,700 and 27,200. The polydispersity thereof was 2.82.
¹H-NMR (270 MHz): δ= 8.12 - 7.96 (m, 8H), 7.90 - 7.61 (m, 8H), 2.75 (t, J = 7.56 Hz, 4H), 2.35 - 1.92 (m, 20H), 1.59 - 1.32 (m, 54H), 1.18 - 0.81 (m, 36H)

### [Example 3]

A block copolymer (3) was synthesized according to the reaction formula below.

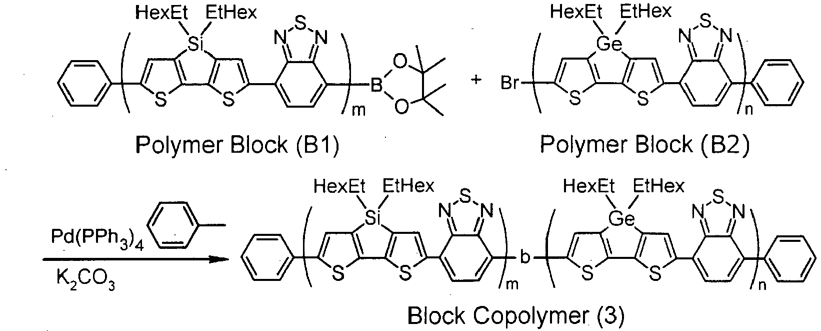

The block copolymer (3) (0.48 g, 29%) was obtained in the same manner as described in Example 1 except that the polymer block (B1) (0.80 g, 1.45 mmol) and the polymer block (B3) (0.86 g, 1.45 mmol) were used. The weight average molecular weight (Mw) and the number average molecular weight (Mn) of the obtained block copolymer (3) were each 85,900 and 41,500. The polydispersity thereof was 2.07.
¹H-NMR (270 MHz): δ = 8.20 - 7.93 (m, 4H), 7.82 - 7.60 (m, 4H), 2.32 - 2.12 (m, 8H), 1.61 - 1.30 (m, 36H), 1.20 - 0.83 (m, 24H)

### [Example 4]

A block copolymer (4) was synthesized according to the reaction formula below.

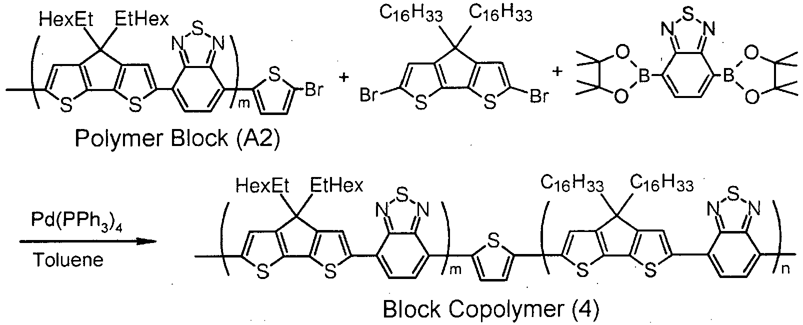

The block copolymer (4) (0.38 g, 67%) was obtained in the same manner as described in Example 2 except that the polymer block (A2) (0.40 g, 0.75 mmol), 2,6-dibromo-4,4'-bis(hexadecyl)cyclopenta[2,1-b:3,4-b']dithiophene (0.59 g, 0.75 mmol) and 4,7-bis(3,3,4,4-tetramethyl-2,5,1-dioxaborolane-1-yl)benzo[c][1,2,5]thiadiazole (0.29 g, 0.75 mmol) which were monomers that would constitute the polymer block (B) were used. The weight average molecular weight (Mw) and the number average molecular weight (Mn) of the obtained block copolymer (4) were each 83,900 and 41,500. The polydispersity thereof was 2.07.
¹H-NMR (270 MHz): δ = 8.13 - 7.94 (m, 4H), 7.82 - 7.35 (m, 4H), 3.04 - 2.90 (m, 4H) 2.35 - 2.12 (m, 12H), 1.60 - 1.30 (m, 30H), 1.35 - 1.20 (m, 36H), 1.18 - 0.82 (m, 18H)

### [Example 5]

A block copolymer (5) was synthesized according to the reaction formula below.

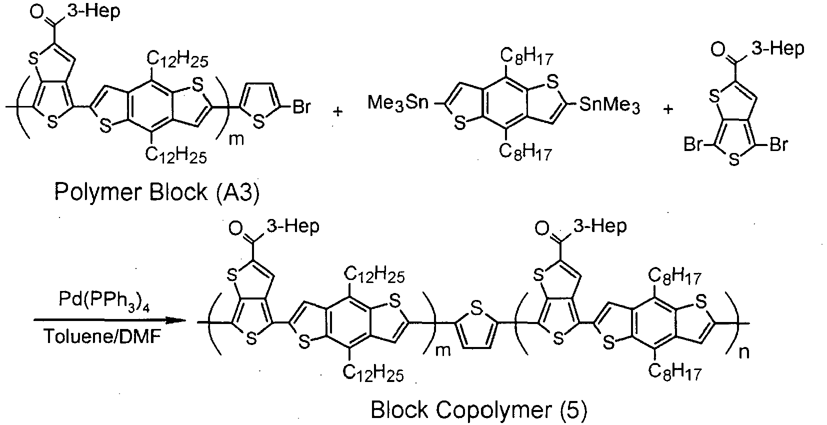

Under a nitrogen atmosphere, in a 50 mL flask, the polymer block (A3) (0.59 g, 0.75 mmol), 2,6-bis(trimethyltin)-4,8-bis(octyl)benzo[1,2-b:4,5-b']dithiophene (0.56 g, 0.75 mmol) and 1-(4,6-dibromothieno[3,4-b]thiophene-2-yl)-2-ethylhexane-1-one (0.32 g, 0.75 mmol) which were monomers that would constitute the polymer block (B) were added. Further, DMF (3 mL), toluene (12 mL) and tetrakis(triphenylphosphine)palladium(0) (30 mg, 26 µmol) were added. After 20 minutes gas bubbling in the container was carried out with argon gas, the mixture was heated for 10 hours at 110°C. After completion of the reaction, the reacted mixture was poured into methanol (300 mL). The precipitated solid was collected by filtration, dried under reduced pressure, obtaining a crude product. The crude product was washed with acetone (200 mL) and hexane (200 mL), then extracted with chloroform (200 mL) using a Soxhlet extractor. The resulting solution was concentrated and poured into methanol (300 mL). The precipitated solid was collected by filtration, then dried under reduced pressure, obtaining the block copolymer (5) (0.50 g, 45%) as a black purple solid. The weight average molecular weight (Mw) and the number average molecular weight (Mn) of the obtained block copolymer (5) were each 84,600 and 28,800. The polydispersity thereof was 2.99.
¹H-NMR (270 MHz): δ = 7.60 - 7.30 (br, 6H), 4.40 - 4.00 (br, 8H), 3.20 - 3.00 (br, 2H), 2. 00 - 0.60 (br, 176H)

### [Example 6]

A block copolymer (6) was synthesized according to the reaction formula below.

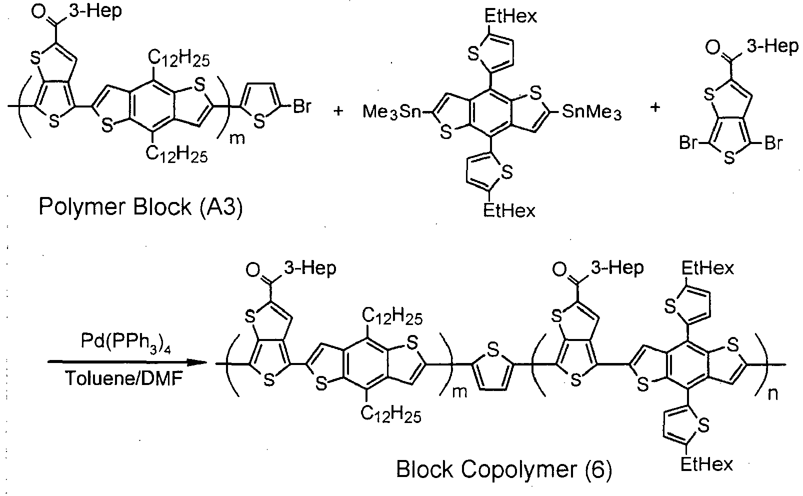

The block copolymer (6) (0.48 g, 76%) was obtained in the same manner as described in Example 5 except that the polymer block (A3) (0.59 g, 0.75 mmol), 2,6-bis(trimethyltin)-4,8-bis(5-(2-ethylhexyl)thiophene-2-yl)benzo[1,2-b:4,5-b'] dithiophene (0.68 g, 0.75 mmol) and 1-(4,6-dibromothieno[3,4-b]thiophene-2-yl)-2-ethylhexane-1-one (0.32 g, 0.75 mmol) which were monomers that would constitute the polymer block (B) were used. The weight average molecular weight (Mw) and the number average molecular weight (Mn) of the obtained block copolymer (6) were each 67,600 and 27,500. The polydispersity thereof was 2.46.
¹H-NMR (270 MHz, CDCl₃): δ = 7.60 - 7.30 (br, 8H), 6.95 - 6.85 (br, 2H), 3.30 - 3.00 (br, 6H), 2.85 - 2.75 (Br, 4H), 2.00 - 0.60 (br, 104H)

### [Example 7]

A block copolymer (7) was synthesized according to the reaction formula below.

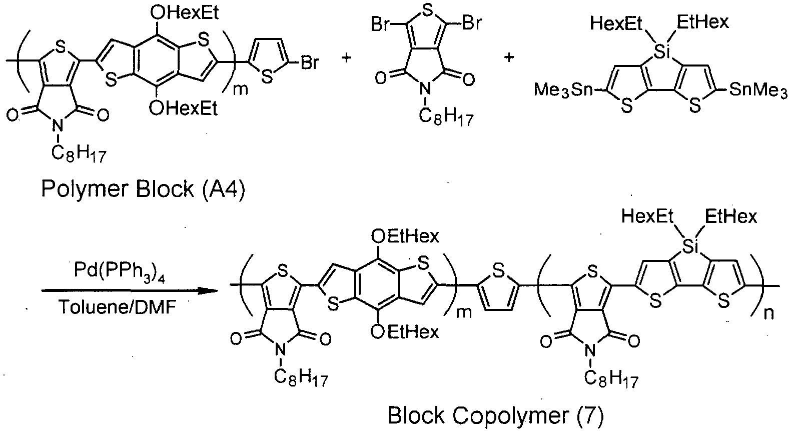

Under an argon atmosphere, in a 50 mL eggplant flask, the polymer block (A4) (0.53 g, 0.75 mmol), 4,4-bis(2-ethylhexyl)-2,6-bis(trimethyltin)dithieno[3,2-b:2',3'-d']silole (0.56 g, 0.75 mmol) and 3-dibromo-5-octylthieno[3,4-c]pyrrole-4,6-dione (0.32 g, 0.75 mmol) which were monomers that would constitute the polymer block (B) were added. Further, DMF (3.0 mL), toluene (12 mL) and tetrakis(triphenylphosphine)palladium(0) (60 mg, 0.05 mmol) were added. After 20 minutes gas bubbling in the container was carried out with argon gas, the mixture was heated for 5 hours at 110°C. After completion of the reaction, the reacted mixture was poured into methanol (300 mL). The precipitated solid was collected by filtration, dried under reduced pressure, obtaining a crude product. The crude product was washed with acetone (200 mL), hexane (200 mL) and dichloromethane (200 mL), then extracted with chloroform (200 mL) using a Soxhlet extractor. The resulting solution was concentrated and poured into methanol (300 mL). The precipitated solid was collected by filtration, then dried under reduced pressure, obtaining the block copolymer (7) (0.37 g, 73%) as a black purple solid. The weight average molecular weight (Mw) and the number average molecular weight (Mn) of the obtained block copolymer (7) were each 374,000 and 96,000. The polydispersity thereof was 3.90.
¹H-NMR (270 MHz): δ = 8.61 - 8.50 (br, 3H), 7.60 - 7.30 (br, 1H), 4.65 - 3.55 (br, 8H), 2. 00 - 1.25 (m, 82H), 1.00 - 0.90 (m, 30H)

### [Example 8]

A block copolymer (8) was synthesized according to the reaction formula below.

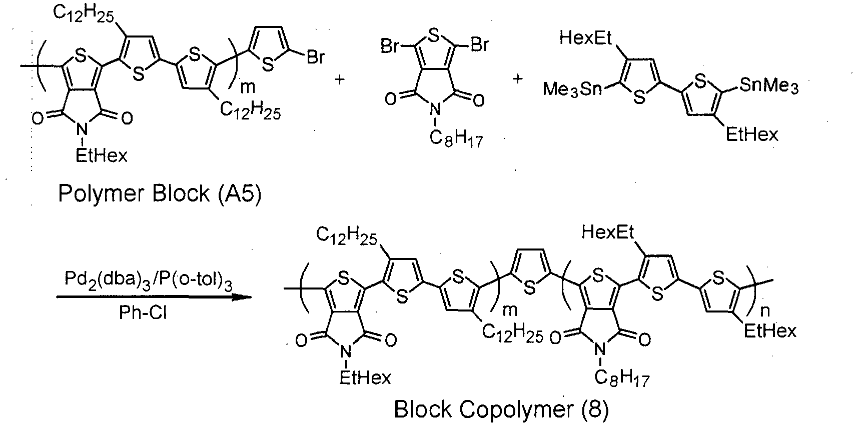

Under a nitrogen atmosphere, in a 50 mL eggplant flask, tris(o-tolyl)phosphine (37 mg, 0.12 mmol), tris(dibenzylideneacetone)dipalladium (14 mg, 15 µmol) and chlorobenzene (32 mL) were added and heated for 10 minutes at 50°C. After heating, the temperature was once cooled to room temperature. The polymer block (A5) (0.57 g, 0.75 mmol), 1,3-dibromo-5-(2-ethylhexyl)thieno[3,4-c]pyrrole-4,6-dione(0.32 g, 0.75 mmol) and 4,4'-di(2-ethylhexyl)-5,5'-trimethyltin-2,2'-bithiophene (0.54 g, 0.75 mmol) which were monomers that would constitute the polymer block (B), were added and heated for 3 hours at 130°C. After that, using the same method as described in the Polymerization Example 5, the block Copolymer (8) (0.85 g, 80%) was obtained. The weight average molecular weight (Mw) and the number average molecular weight (Mn) of the obtained block copolymer (8) were each 370,000 and 88,000. The polydispersity thereof was 4.21.
¹H-NMR (270 MHz): δ = 7.17 (s, 4H), 3.58 - 3.54 (br, 4H), 2.84 - 2.81 (br, 8H), 1.88 - 1. 27 (m, 98H), 0.95 - 0.86 (br, 24H)

### [Example 9]

A block copolymer (9) was synthesized according to the reaction formula below.

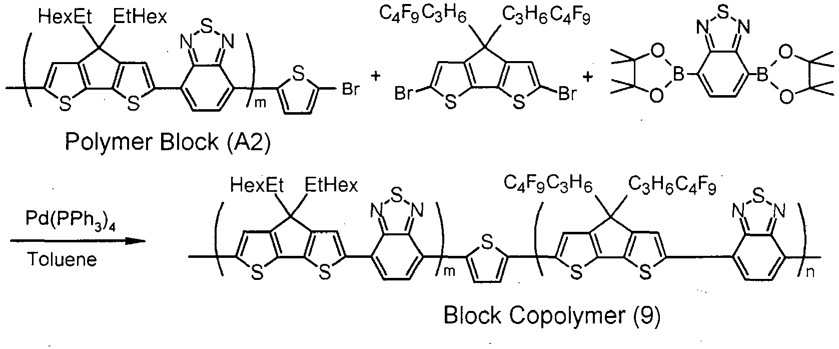

The block copolymer (9) (0.48 g, 75%) was obtained in the same manner as described in Example 2 except that the polymer block (A2) (0.50 g, 0.94 mmol), 2,6-dibromo-4,4'-bis(4,4,5,5,6,6,7,7,7-nonafluoroheptyl)cyclopenta[2,1-b:3,4-b']dithio phene (0.82 g, 0.47 mmol) and 4,7-bis(3,3,4,4-tetramethyl-2,5,1-dioxaborolane-1-yl)benzo[c][1,2,5]thiadiazole (0.36 g, 0.94 mmol) which were monomers that would constitute the polymer block (B) were used. The weight average molecular weight (Mw) and the number average molecular weight (Mn) of the obtained block copolymer (9) were each 83,900 and 41,500. The polydispersity was 2.07.
¹H-NMR (270 MHz): δ= 8.12 - 7.96 (m, 4H), 7.90 - 7.61 (m, 4H), 2.75 (t, J = 7.56 Hz, 4H), 2.35-1.92 (m, 12H), 1.59 - 1.32 (m, 18H), 1.18 - 0.81 (m, 12H)

### [Example 10]

A block copolymer (10) was synthesized according to the reaction formula below.

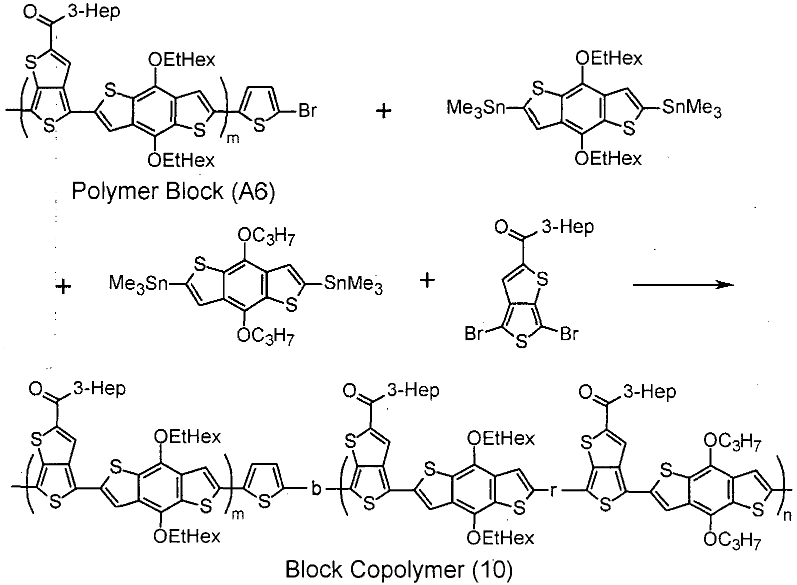

Under an argon atmosphere, in a 5 mL flask, the polymer block (A6) (60.0 mg, 0.08 mol), 2,6-bis(trimethyltin)-4,8-bis(2-ethylhexyloxy)benzo[1,2-b:4,5-b']dithiophene (58.5 mg, 0.076 mmol) and 2,6-bis(trimethyltin)-4,8-bis(propyloxy)benzo[1,2-b:4,5-b']dithiophene (25.2 mg, 0.05 mmol) and 1-(4,6-dibromothieno[3,4-b]thiophene-2-yl)-2-ethylhexane-1-one (36.0 mg, 0.085 mmol) which were monomers that would constitute the polymer block (B) were added. Further, DMF (0.3 mL), toluene (1.4 mL) and tetrakis(triphenylphosphine)palladium(0) (3.4 mg, 2.98 µmol) were added. After 20 minutes gas bubbling in the container was carried out with argon gas, the mixture was heated for 10 hours at 110°C. After completion of the reaction, the reacted mixture was poured into methanol (500 mL). The precipitated solid was collected by filtration, dried under reduced pressure, obtaining a crude product. The crude product was washed with acetone (200 mL) and hexane (200 mL), then extracted with chloroform (200 mL) using a Soxhlet extractor. The obtained solution was poured into methanol (300 mL). The precipitated solid was collected by filtration, then dried under reduced pressure, obtaining the block copolymer (10) (0.50 g, 35%) as a black purple solid. The weight average molecular weight (Mw) and the number average molecular weight (Mn) of the obtained block copolymer (10) were each 154,000 and 55,000. The polydispersity thereof was 2.80.
¹H-NMR (270 MHz, CDCl₃): δ = 7.60 - 7.30 (br, 3H), 4.40 - 4.00 (br, 4H), 3.20 - 3.00 (Br, 1H), 2.00 - 0.60 (br, 39H)

### [Example 11]

A block copolymer (11) was synthesized according to the reaction formula below.

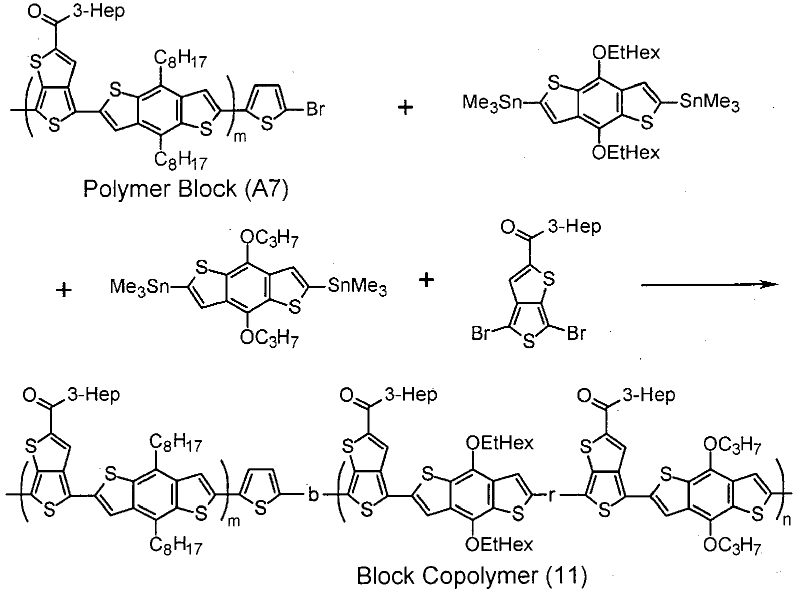

The block copolymer (11) (105.5 mg, 66.4%) was obtained in the same manner as described in Example 10 except that the polymer block (A7) (80.0 mg, 0.12 mol), 2,6-bis(trimethyltin)-4,8-bis(2-ethylhexyloxy)benzo[1,2-b:4,5-b']dithiophene (71.4 mg, 0.09 mmol), 2,6-bis(trimethyltin)-4,8-bis(propyloxy)benzo[1,2-b:4,5-b']dithiophene (25.1 mg, 0.04 mmol) and 1-(4,6-dibromothieno[3,4-b]thiophene-2-yl)-2-ethylhexane-1-one (50.1 mg, 0.12 mmol) which were monomers that would constitute the polymer block (B) were used. The weight average molecular weight (Mw) and the number average molecular weight (Mn) of the obtained block copolymer (11) were each 144,000 and 41,000. The polydispersity thereof was 3.50.
¹H-NMR (270 MHz, CDCl₃): δ = 7.60 - 7.30 (br, 3H), 4.40 - 4.00 (br, 4H), 3.20-3.00 (br, 3H), 2.00 - 0.60 (br, 41H)

### [Example 12]

A block copolymer (12) was synthesized according to the reaction formula below.

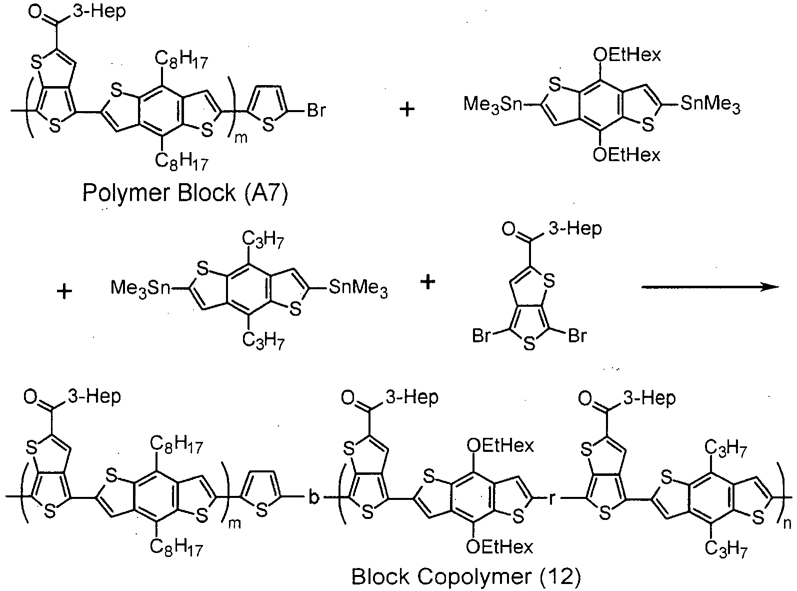

The block copolymer (12) (116.1 mg, 73.1%) was obtained in the same manner as described in Example 10 except that the polymer block (A7) (80.0 mg, 0.12 mol), 2,6-bis(trimethyltin)-4,8-bis(2-ethylhexyloxy)benzo[1,2-b:4,5-b']dithiophene (71.4 mg, 0.09 mmol), 2,6-bis(trimethyltin)-4,8-bis(propyloxy)benzo[1,2-b:4,5-b']dithiophene (23.8 mg, 0.04 mmol) and 1-(4,6-dibromothieno[3,4-b]thiophene-2-yl)-2-ethylhexane-1-one (50.1 mg, 0.12 mmol) which were monomers that would constitute the polymer block (B) were used. The weight average molecular weight (Mw) and the number average molecular weight (Mn) of the obtained block copolymer (12) were each 204,000 and 53,000. The polydispersity thereof was 3.83.
¹H-NMR (270 MHz, CDCl₃): δ = 7.60 - 7.30 (br, 3H), 4.40 - 4.00 (br, 4H), 3.30 - 3.00 (Br, 4H), 2.00 - 0.60 (br, 41H)

### [Example 13]

A block copolymer (13) was synthesized according to the reaction formula below.

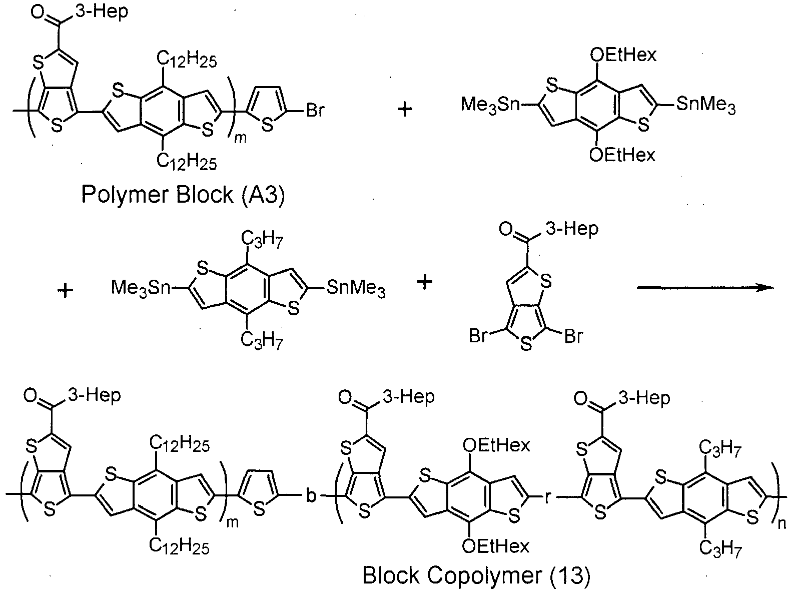

The block copolymer (13) (221.0 mg, 75.4%) was obtained in the same manner as described in Example 10 except that the polymer block (A3) (160.0 mg, 0.12 mol), 2,6-bis(trimethyltin)-4,8-bis(2-ethylhexyloxy)benzo[1,2-b:4,5-b']dithiophene (113.0 mg, 0.16 mmol), 2,6-bis(trimethyltin)-4,8-bis(propyloxy)benzo[1,2-b:4,5-b']dithiophene (40.9 mg, 0.07 mmol) and 1-(4,6-dibromothieno[3,4-b]thiophene-2-yl)-2-ethylhexane-1-one (86.0 mg, 0.20 mmol) which were monomers that would constitute the polymer block (B) were used. The weight average molecular weight (Mw) and the number average molecular weight (Mn) of the obtained block copolymer (13) were each 86,400 and 28,800. The polydispersity thereof was 2.99.
¹H-NMR (270 MHz, CDCl₃): δ = 7.60 - 7.30 (br, 3H), 4.40 - 4.00 (br, 4H), 3.30 - 3.00 (Br, 4H), 2.00 - 0.60 (br, 51H)

### [Preparation of a mixed solution of the Block Copolymer and the Electron accepting material]

The block copolymer (1) (16 mg), PCBM (E100H, produced by Frontier Carbon Corporation.) (12.8mg) as an electron accepting material and chlorobenzene (1 mL) as a solvent were mixed over 6 hours at 40°C. Then cooled to 20°C (room temperature) and then filtered through a PTFE filter with a pore size of 0.45 µm, obtaining a solution containing the block copolymer and PCBM. By the same method, a solution containing PCBM and each block copolymer obtained in Examples 2 to 13 was prepared.

### [Production of Organic Thin Film Solar Cell with a Layer of Block Copolymer Composition]

A glass substrate with an ITO film (resistance 10Ω / □) with a thickness of 150 nm provided by sputtering was subjected to a surface treatment using ozone UV for 15 minutes. A layer that is used as a hole transporting layer provided on the surface-treated substrate was deposited to a thickness of 40nm by spin coating from PEDOT : PSS aqueous solution (CLEVIOS PH500 produced by H. C. Starck Inc.). After 20 minutes heating and drying at 140°C with a hot plate, a solution containing the PCBM and each block copolymer was spin coated to form an organic photoelectric conversion layer for organic thin film solar cell (thickness: about 100 nm). After vacuum drying for 3 hours and thermal annealing for 30 minutes at 120°C, by vacuum deposition method, lithium fluoride was deposited with a thickness of 1 nm using a vacuum deposition device, and then Al was deposited with a film thickness of 100 nm. Thus, an organic thin film solar cell or a photoelectric conversion element having a layer formed from a composition comprising the block copolymer obtained in Examples 1 - 13 was obtained. Shape of the organic thin film solar cell was a square of 5 × 5 mm.

### [Comparative Example 1]

The polymer block (B1) (13 mg) and the polymer block (A1) (3 mg) as a π-electron conjugated polymer, PCBM (E100H, produced by Frontier Carbon Corporation.) (16 mg) as an electron accepting material, and ortho-dichlorobenzene (1 mL) as a solvent were mixed over 6 hours at 40°C. Then the mixture was cooled to 20°C (room temperature), and was filtered through a PTFE filter with a pore size of 0.45 µm, obtaining a solution containing the π-electron conjugated polymer blend and PCBM. An organic thin film solar cell in Comparative Example 1 was fabricated by using this solution in the same manner as described above.

### [Comparative Example 2]

A diblock copolymer comprising a copolymer block of alkylfluorene and bis(alkylthienyl)benzothiadiazole and a copolymer block of alkylfluorene and pentameric thiophene was synthesized (a detailed procedure of the synthesis is described in Japan Patent Application Publication No. 2008-266459 (Patent Document 1)). A mixed solution containing the electron accepting material was prepared in the same manner as described in Example 1. An organic thin film solar cell of Comparative Example 2 was formed using the mixed solution.

### [Evaluation of Organic Thin Film Solar Cells]

Photoelectric conversion efficiencies of organic thin film solar cells of each Examples and Comparative Examples were measured using a 300W Solar Simulator (produced by Peccell Technologies Inc., trade name: PEC L11 AM1.5G filter, irradiance 100 mW/cm²). Measurement results are shown in Tables 1-3.

**Table 1**

| | Block Copolymer | Polymer Block (A) | Polymer Block (B) | Photoelectric Conversion Efficiency (%) |
|---|---|---|---|---|
| Ex.1 | Block Copolymer (1) | 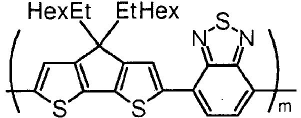 | 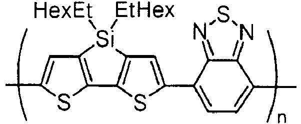 | 3.2 |
| Ex.2 | Block Copolymer (2) | 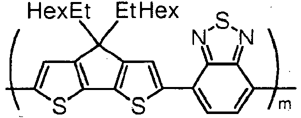 | 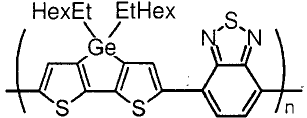 | 3.5 |
| Ex.3 | Block Copolymer (3) | 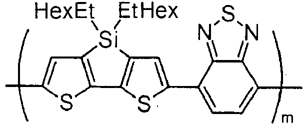 | 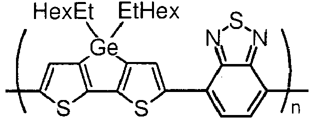 | 3.1 |
| Ex.4 | Block Copolymer (4) | 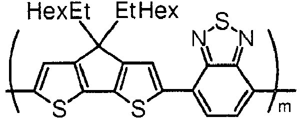 | 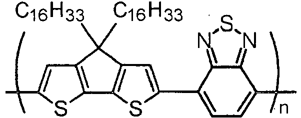 | 3.4 |
| Ex.5 | Block Copolymer (5) | 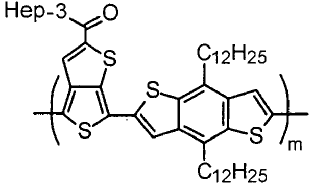 | 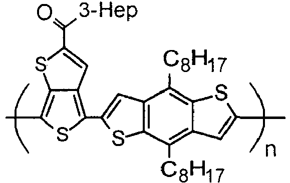 | 6.3 |
| Ex.6 | Block Copolymer (6) | 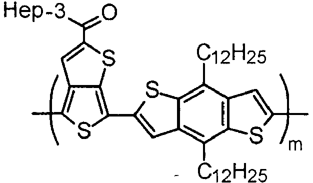 | 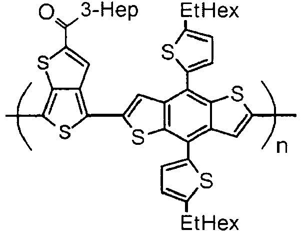 | 6.2 |

**Table 2**

| | Block Copolymer | Polymer Block (A) | Polymer Block (B) | Photoelectric Conversion Efficiency (%) |
|---|---|---|---|---|
| Ex.7 | Block Copolymer (7) | 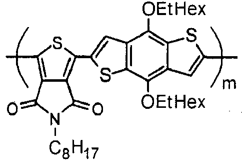 | 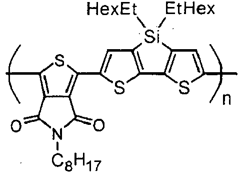 | 6.3 |
| Ex.8 | Block Copolymer (8) | 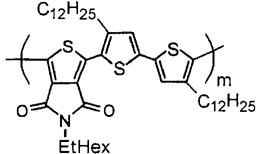 | 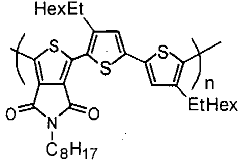 | 5.8 |
| Ex.9 | Block Copolymer (9) | 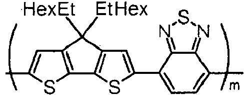 | 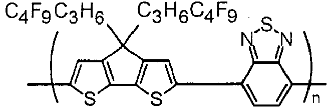 | 3.5 |
| Ex. 10 | Block Copolymer (10) | 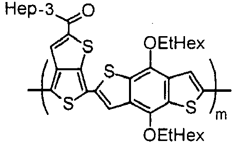 | 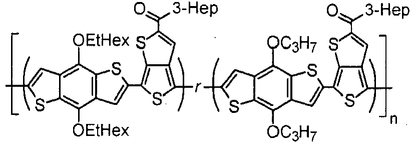 | 6.0 |
| Ex.11 | Block Copolymer (11) | 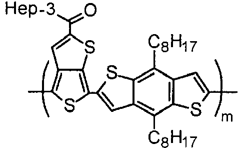 | 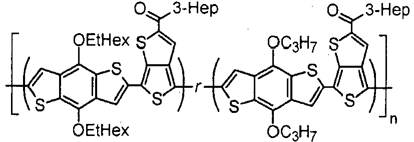 | 5.4 |
| Ex.12 | Block Copolymer (12) | 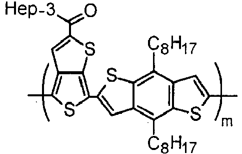 | 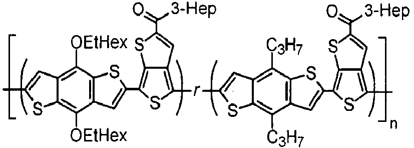 | 6.0 |
| Ex.13 | Block Copolymer (13) | 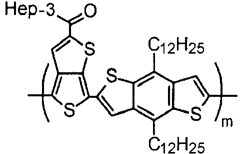 | 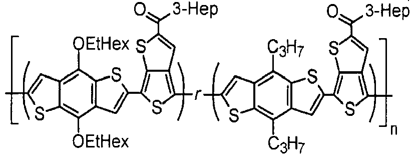 | 7.0 |

**Table 3**

| | Block Copolymer | Polymer Block (A) | Polymer Block (B) | Photoelectric Conversion Efficiency (%) |
|---|---|---|---|---|
| Comp. Ex.1 | Mixture of Polymer Block (A1) and Polymer Block (B1) | 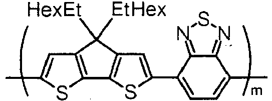 | 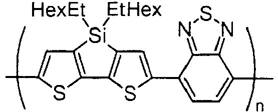 | 2.7 |
| Comp. Ex. 2 | Polymer Described in Patent Document 1 | 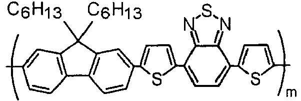 | 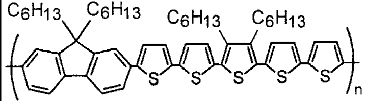 | 2.4 |

As clearly seen from Tables 1 - 3, the organic thin film solar cells made of the π-electron conjugated block copolymer of Examples have higher photoelectric conversion efficiencies when compared to the organic thin film solar cells made of conjugated polymers or π-electron conjugated block copolymers of Comparative Examples.

### INDUSTRIAL APPLICABILITY

The novel π-electron conjugated block copolymers of the present invention can be utilized as the photoelectric conversion layers for the photoelectric conversion elements. The photoelectric conversion element made of the present copolymers can be used for optical sensors of various types as well as solar cells.

## Claims

1. A π-electron conjugated block copolymer comprising:
a polymer block (A) and a polymer block (B), each of which involves a monomer unit having at least one fused π-conjugated skeleton including at least one thiophene ring in one part of the chemical structure thereof;
the polymer block (A) and the polymer block (B) have different monomer units from each other in such a manner that;
heteroaryl skeletons that constitute main chains of the monomer units are different from each other; a numerical difference between carbon atoms of substituents of the monomer units is 4 or more; or a sum of hetero atoms in the substituent of the monomer unit of the polymer block (A) is 2 or less, and a sum of hetero atoms in the substituent of the monomer unit of the polymer block (B) is 4 or more.

2. The π-electron conjugated block copolymer according to Claim 1,
wherein the polymer block (A) and the polymer block (B) include a monomer unit of -a-b-,
- a- is a monomer unit having any one of groups represented by the following formulas (1) - (6), 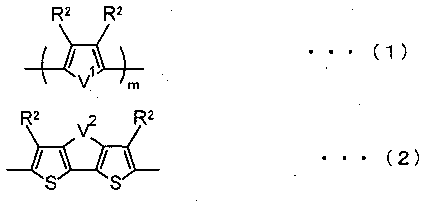 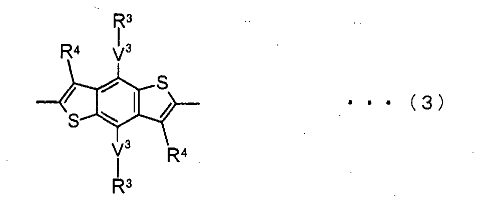 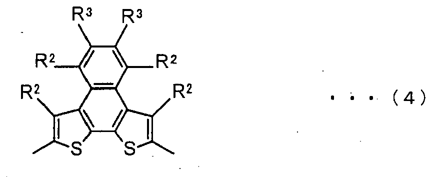 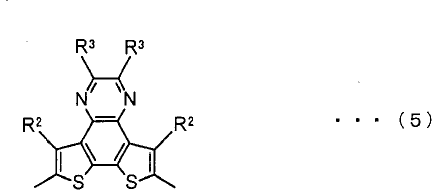 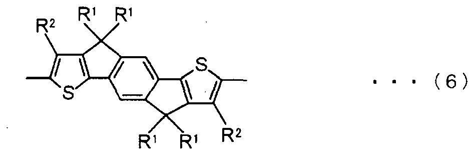 and
- b- is a monomer unit having any one of groups represented by the following formulas (7) - (17), 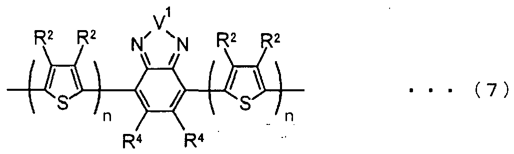 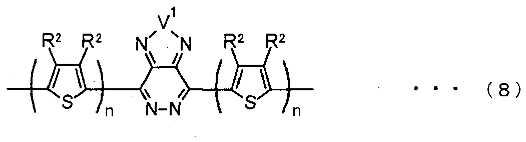 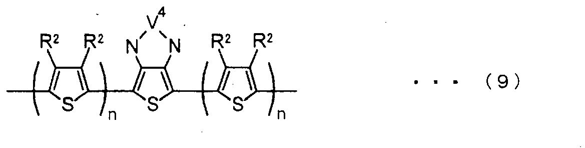 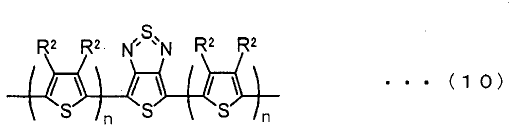 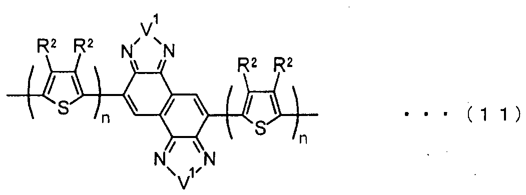 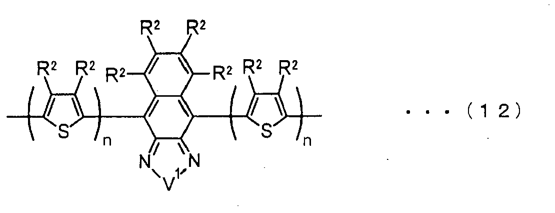 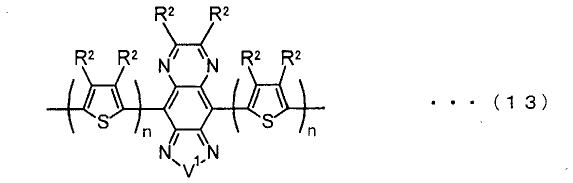 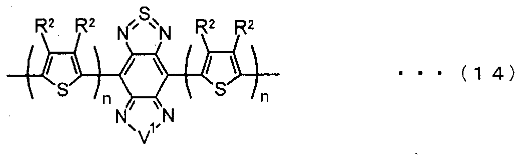 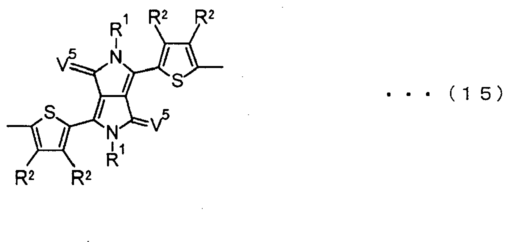 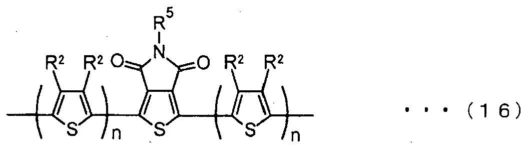 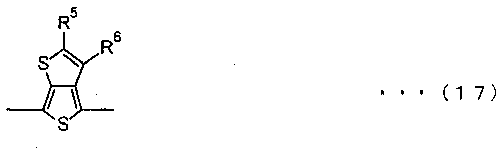
here, at least either -a- or -b- has a group having a fused π-conjugated skeleton containing in one part of chemical structure thereof the thiophene ring, and in the formulas (1) - (17), V¹ is a nitrogen (-NR¹), oxygen (-O-) or sulfur (-S-), V² is a carbon (-CR¹₂-), nitrogen (-NR¹-), silicon (-SiR¹₂-) or germanium (-GeR¹₂-), V³ is an aryl group or heteroaryl group represented by -(Ar)ₙ-, V⁴ is a nitrogen (-NR¹-), oxygen (-O-) or -CR² = CR²-, and V⁵ is an oxygen (-O-) or sulfur (-S-);
R¹ is an alkyl group having 1 - 18 carbon atoms which may be each independently substituted, R² is each independently a hydrogen atom, a carbon atom or an alkyl group having 1 - 18 carbon atoms which may be substituted, R³ is an alkoxy group or an alkyl group having 1 - 18 carbon atoms which may be each independently substituted, R⁴ is each independently a hydrogen atom, a halogen atom, or an aryl group or an alkyl group having 1 - 18 carbon atoms which may be substituted; R⁵ is an alkyl or aryl or alkylcarbonyl or alkyloxycarbonyl group having 1 - 18 carbon atoms which may be substituted; and R⁶ is a hydrogen atom or a halogen atom;
m is an integer of 1 - 3, and n is an integer of 0 - 3.

3. The π-electron conjugated block copolymer according to Claim 2,
wherein the monomer unit -a-b- includes any one of monomer units selected from the following formulas (18) - (28), 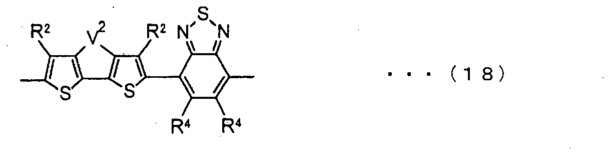 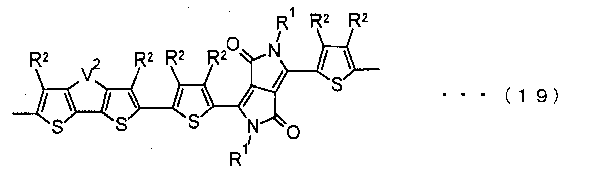 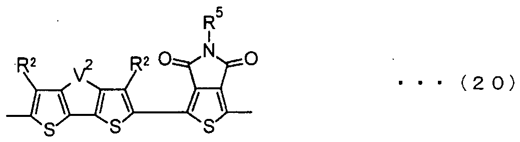 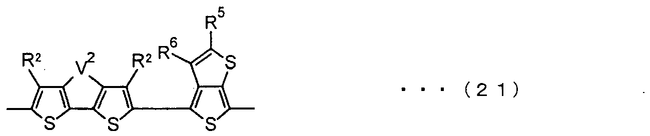 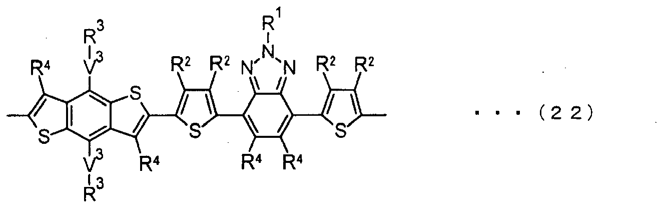 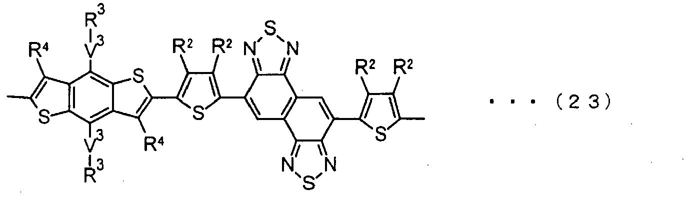 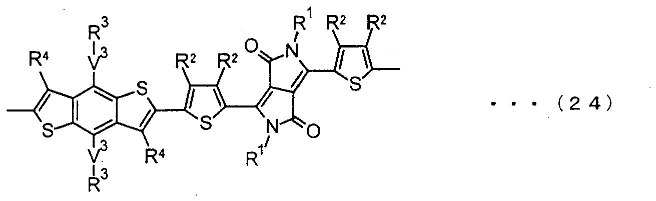 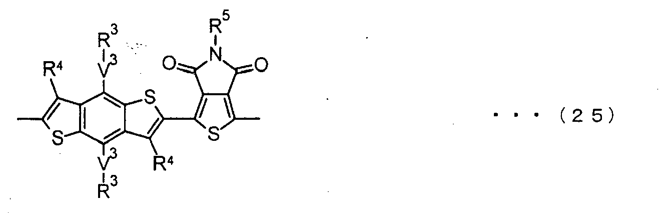 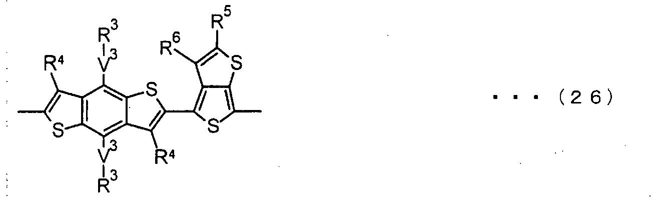 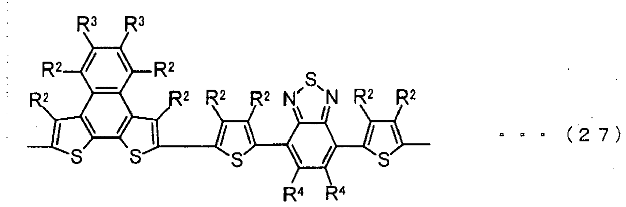 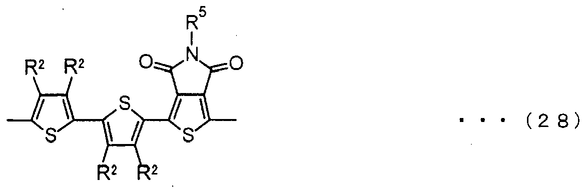 in the formulas (18) - (28), V² represents a carbon (-CR¹₂-), nitrogen (-NR¹-), silicon (-SiR¹₂-), or germanium (-GeR¹₂-); V³ is an aryl or heteroaryl group represented by -(Ar)ₙ-;
R¹, R², R³, R⁴, R⁵ and R⁶ are the same meanings as defined above;
n represents an integer of 0 - 3.

4. The π-electron conjugated block copolymer according to Claim 1,
wherein at least one of the polymer block (A) or the polymer block (B) is a random copolymer comprising a plural types of the monomer units.

5. The π-electron conjugated block copolymer according to Claim 4,
wherein the random copolymer comprises a plurality of different monomer units -a-b- which are different from each other.

6. The π-electron conjugated block copolymer according to any one of Claims 1 - 5,
of which a number average molecular weight is in the range of 1,000 - 200,000 g/mol.

7. A composition comprising an electron accepting material and the π-electron conjugated block copolymer according to any one of Claims 1 - 6.

8. A photoelectric conversion element comprising a layer consisting essentially of the composition according to Claim 7.

9. The photoelectric conversion element according to Claim 8,
wherein the electron accepting material is a fullerene or/and a derivative thereof.
